# EUROPÄISCHE PATENTSCHRIFT

(11) **EP 4 013 715 B1**
(45) Veröffentlichungstag und Bekanntmachung des Hinweises auf die Patenterteilung: **05.08.2026**
(21) Anmeldenummer: 20757242.1
(22) Anmeldetag: 07.08.2020
(51) Int. Cl.: B81B 3/00

(54) **MIKROSYSTEM UND VERFAHREN ZUM HERSTELLEN DESSELBEN**
MICROSYSTEM AND METHOD FOR PRODUCING SAME
MICROSYSTÈME ET PROCÉDÉ DE PRODUCTION CORRESPONDANT

(30) Priorität: 13.08.2019 DE 102019212091
(43) Veröffentlichungstag der Anmeldung: 22.06.2022
(73) Patentinhaber: Fraunhofer-Gesellschaft zur Förderung der angewandten Forschung e.V., 80686 München (DE)
(72) Erfinder: LISEC, Thomas, 25524 Itzehoe (DE); NIEKIEL, Malte Florian, 25524 Itzehoe (DE); GU-STOPPEL, Shanshan, 25524 Itzehoe (DE); LOFINK, Fabian, 25524 Itzehoe (DE)
(74) Vertreter: König, Andreas Rudolf
(86) Internationale Anmeldenummer: PCT/EP2020/072267
(87) Internationale Veröffentlichungsnummer: WO 2021/028345

(56) Entgegenhaltungen:
- EP-A2- 0 306 178
- WO-A1-2016/005325
- DE-A1- 102011 010 899
- DE-A1- 102016 215 616
- DE-A1- 102017 123 431
- US-A1- 2007 209 437
- JACKSON NATHAN ET AL: "Integration of Thick-Film Permanent Magnets for MEMS Applications", JOURNAL OF MICROELECTROMECHANICAL SYSTEMS, IEEE SERVICE CENTER, US, vol. 25, no. 4, 1 August 2016 (2016-08-01), pages 716 - 724, XP011618146, ISSN: 1057-7157, [retrieved on 20160729], DOI: 10.1109/JMEMS.2016.2574958

## Beschreibung

Die vorliegende Erfindung bezieht sich auf ein Mikrosystem und auf ein Verfahren zum Herstellen desselben, wobei insbesondere Mikrosysteme beschrieben werden, die ein permanentmagnetisches Element aufweisen. Die vorliegende Erfindung bezieht sich ferner auf eine magnetische Positionsdetektion für MEMS.

In vielen MEMS-Anwendungen (MEMS = mikroelektromechanisches System) ist es notwendig, die Position der beweglichen Mikrostruktur präzise zu überwachen, z. B. als Steuersignal in geschlossenen Regelkreisen. Hierfür werden vor allem kapazitive, piezoresistive oder piezoelektrische Sensorelemente genutzt, die im MEMS-Bauteil integriert werden können. Die Überwachung großer Stellwege und Verkippungen auf engstem Raum ist allerdings nur eingeschränkt möglich. Eine Alternative ist die magnetische Positionsdetektion, basierend auf der Beobachtung des Magnetfelds eines an der beweglichen Struktur befestigten Permanentmagneten. Es existieren Lösungen, die auf der Nutzung hybrid montierter, konventioneller Miniaturmagnete basieren. Diese sind für Massenanwendungen jedoch ungeeignet.

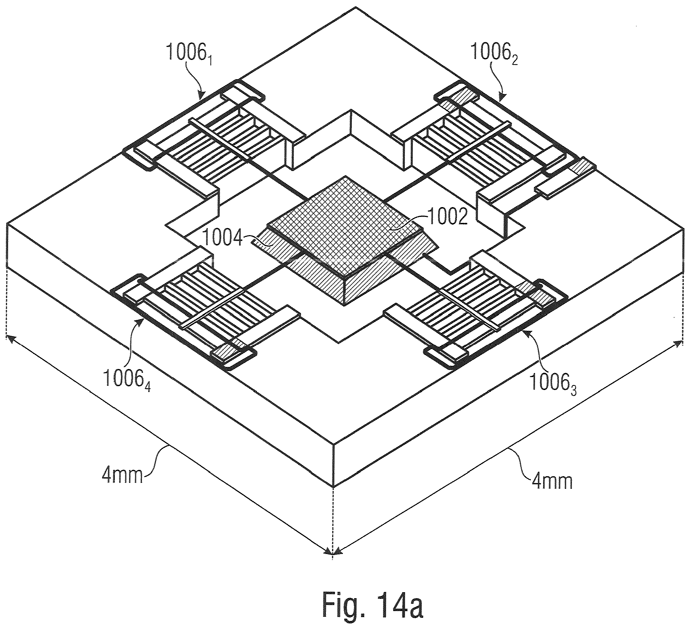

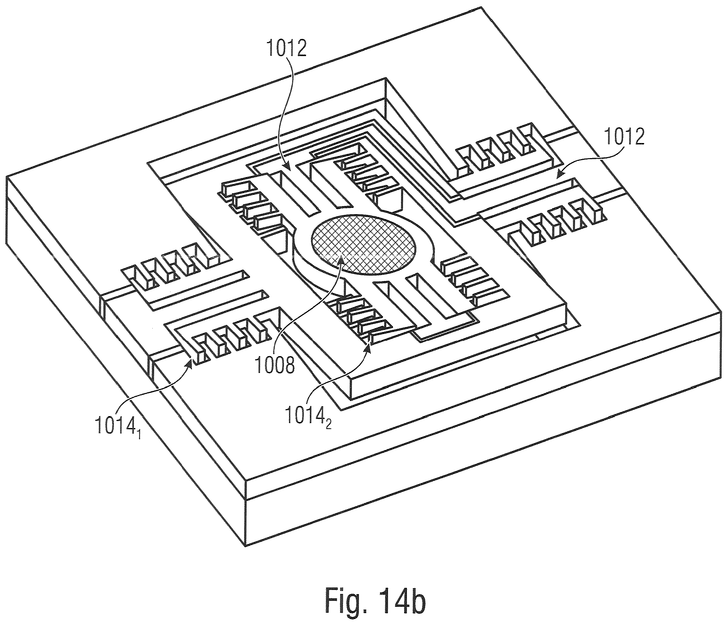

Eine häufig genutzte Technik ist die kapazitive Positionsdetektion unter Verwendung planarer oder kammartiger Elektrodenpaare, wobei eine der Elektroden am beweglichen Element angeordnet ist, wie es in Fig. 14a und Fig. 14b schematisch dargestellt ist. Fig. 14a zeigt dabei eine dreidimensional bewegliche Plattform 1002 (engl.: 3D-Stage), die gegenüber einer Gegenelektrode oder Bodenelektrode 1004 beweglich ist und über Aktuatoren 1006₁ - 1006₄ angetrieben werden kann. Fig. 14b zeigt dahingehend einen MEMS-Scanner, bei dem ein Mikrospiegel 1008 über Torsionsbalken 1012 und Kammelektroden 1014₁ und 1014₂ ausgelenkt werden kann. Das bedeutet, die Fig. 14a und 14b zeigen Beispiele für MEMS-Bauteile mit elektrostatischem Antrieb und kapazitiver Positionsdetektion unter Verwendung ineinandergreifender Fingerstrukturen (engl.: comb electrodes, comb-drive actuators). Hauptvorteile sind die einfache Integration in MEMS-Bauelemente aufgrund der zur Verfügung stehenden Fertigungsprozesse und die Verfügbarkeit integrierter Schaltungen, die Auflösungen im Bereich weniger fF (Femtofarad) erlauben. Die kapazitive Positionsdetektion eignet sich jedoch nur für sehr geringe Stellwege, da die Kapazität proportional zum Kehrwert des Elektrodenabstands ist und so in der einfachen Parallel-Plattenkonfiguration mit wachsendem Elektrodenabstand sehr schnell abnimmt. Eine Verbesserung bietet hier die Verwendung von Fingerstrukturen, die den Elektrodenabstand konstant halten. Das kapazitive Signal ist in dem Falle direkt proportional zur Überlappung der Fingerflächen. Durch die notwendige Präzision bei der Fertigung sind die herstellbaren Fingerstrukturen geometrisch stark eingeschränkt, wodurch es wiederum zu einer Limitierung der überwachbaren Stellwege kommt. Bei der 3D-Stage gemäß Fig. 14a, wie sie beispielsweise in [1] beschrieben ist, sind es beispielsweise in x- und y-Richtung 12,5 µm und in z-Richtung 3,5 µm. Bei dem MEMS-Scanner gemäß Fig. 14b, welcher in [2] beschrieben ist, wird ein (mechanischer) Kippwinkel von bis zu 20° überwacht. Die wenigsten Anwendungen der kapazitiven Positionsdetektion sind Inertialsensoren und MEMS-Scanner.

Eine Alternative ist die piezoresistive Positionsdetektion. Im Vergleich zur kapazitiven Detektion können größere Stellwege überwacht werden. Die Integration von Piezowiderständen in MEMS-Bauelemente ist jedoch erheblich aufwendiger im Vergleich zu den für kapazitive Detektion benötigten Elektroden. Für eine hohe Empfindlichkeit werden zudem vier Widerstände zu einer Wheatstone'schen Messbrücke verschaltet, was in erhöhtem Platzbedarf resultiert. Für einen MEMS-Scanner, der beispielsweise in [3] beschrieben ist, und der eine Positionsdetektion in der x/y-Ebene ermöglicht, werden beispielsweise insgesamt 16 Piezowiderstände benötigt.

Ein essentieller Nachteil der kapazitiven und piezoresistiven Positionsdetektion ist, dass die Signalerfassung nicht berührungsfrei erfolgen kann, sondern elektrische und mechanische Verbindungen zu den sensorischen Elementen erforderlich sind, d. h., spezielle elastische Strukturen innerhalb des MEMS-Bauelements sind vonnöten. Mit zunehmendem Stellweg müssen die benötigten elastischen Strukturen immer größer werden, um eine entsprechende Deformation zu ermöglichen. Zudem kommt es in beiden Fällen zu einer mechanischen Kopplung mit dem Antrieb. Im Falle der piezoresistiven Positionsdetektion ist zusätzliche Kraft notwendig, um die piezoresistiven Elemente zu verformen. Bei der kapazitiven Positionsdetektion resultiert die zu überwindende Kraft aus der elektrostatischen Wechselwirkung.

Von Interesse für MEMS ist daher die in industriellen Anwendungen weit verbreitete berührungslose optische Positionsdetektion. In [4] wird die optische Positionsdetektion z. B. eingesetzt, um einen Sensor für Magnetfelder zu implementieren. Kostengünstige und miniaturisierbare Systeme setzen allerdings voraus, dass Lichtquelle und PSD (Position Sensing Device, positionserfassende Vorrichtung) in das MEMS-Bauelement integriert werden können. Beispiele dafür gibt es beispielsweise in [5].

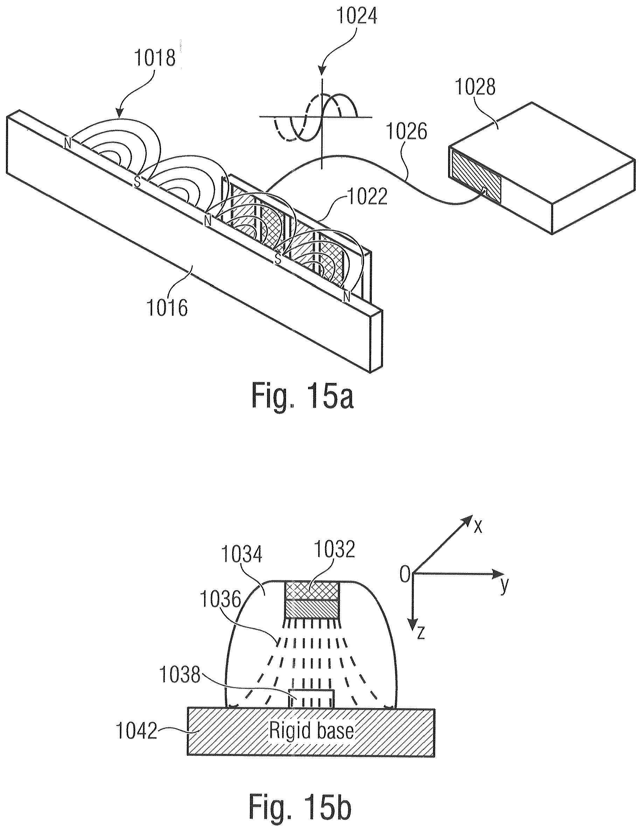

Eine weitere berührungslose Technik ist die magnetische Positionsdetektion. Eine klassische Anwendung ist die Präzisions-Wegmessung bzw. Präzisions-Positionsbestimmung z. B. in Werkzeugmaschinen. Die Positionsdetektion erfolgt hierbei nach dem Encoder-Prinzip, d. h. anhand eines Abgleichs zwischen einem vorgegebenen Muster und einer gemessenen Signalform. Verwendung finden ein magnetischer Linearmaßstab und ein oder mehrere Magnetfeldsensoren, die sich in geringem Abstand darüber hinwegbewegen, wie es beispielsweise in Fig. 15a oder in [6] beschrieben ist. Ein in Fig. 15a schematisch dargestelltes System zur magnetischen Positionsdetektion umfasst einen Magnetmaßstab oder magnetischen Maßstab 1016, um magnetische Feldlinien 1018 zu erzeugen, die mittels eines magnetoresistiven (MR-)Sensors 1022 detektiert werden, um analoge Signale 1024 über ein Verbindungskabel 1026 an eine Auswerteelektronik 1028 zu liefern. Der klassische Maßstab besteht zumeist aus einem hartmagnetischen Ferrit-Band, montiert auf einem Träger aus Edelstahl. Mit modernen MR-Sensoren und optimierten Messalgorithmen kann eine Positioniergenauigkeit von 0,5 µm erzielt werden. Darüber hinaus gibt es Anwendungen, bei denen die magnetische Positionsdetektion nicht nach dem Encoder-Prinzip, sondern über die gemessenen Absolutwerte erfolgt. Oftmals sind die Genauigkeitsanforderungen geringer, wie z. B. bei magnetischen Schaltern zur Detektion offener oder geschlossener Türen oder Fenster oder Sensoren zur Füllstanddetektion in geschlossenen Behältern. Erwähnenswert sind auch taktile Sensoren für die Robotik, wie sie in Fig. 15b dargestellt und in [7] beschrieben sind. Dort wird ein Magnet 1032 von einem Elastomer 1034 umschlossen und erzeugt ein Magnetfeld 1036, welches von einem 3D-Hall-Sensor 1038 erfasst wird. Der Hall-Sensor 1038 kann auf einem festen Substrat 1042 angeordnet sein.

Für MEMS spielt die magnetische Positionsdetektion bisher kaum eine Rolle. Hauptproblem ist das Fehlen geeigneter Mikromagnete, die starke Magnetfelder über große Distanzen erzeugen und auf Substratebene in ein MEMS-Bauelement integriert werden können. Abgesehen vom Material hängen die Eigenschaften insbesondere von den Abmessungen des Magneten ab. Der Gradient, mit dem das Feld eines Magneten abfällt, wird umso steiler, je kleiner der Magnet ist, jedoch sinkt mit kleineren Magneten auch der Absolutwert der Flussdichte. Dabei spielt das Aspekt-Verhältnis des Magneten, d. h., das Verhältnis der Länge (oder Höhe) des Magneten zu dessen Durchmesser (bzw. Grundfläche) eine wesentliche Rolle. Hohe Aspekt-Verhältnisse erlauben die Verwendung kleiner Durchmesser bei gleichbleibender Flussdichte. Gut geeignet für MEMS wären Magnete mit einem Durchmesser über 50 µm und einem Aspekt-Verhältnis von mindestens 3:1. Bei Magneten mit Durchmessern (Kantenlängen) größer 500 µm sind aber auch kleinere Aspekt-Verhältnisse akzeptabel. Allerdings sind die Abscheideprozesse der Halbleitertechnologie nur für Schichten von wenigen Mikrometern ausgelegt. Das Volumen so erzeugter Magnete bleibt weit unterhalb des angestrebten Bereichs. Galvanisch lassen sich zwar Strukturen mit einigen zehn Mikrometern Dicke abscheiden. Entsprechende Prozesse sind jedoch nur für ausgewählte magnetische Materialien verfügbar. In [8] wird z. B. ein Linearmaßstab mit besonders feinteiliger Polstruktur für Messsysteme gemäß Fig. 15a mittel CoNiP-Galvanik auf einem Si-Substrat erzeugt. In [9] wird ein MEMS-Schalter auf Basis einer beweglichen Mikrostruktur aus galvanisch abgeschiedenem FeNi beschrieben, der durch ein magnetisches Feld betätigt wird. Magnetische Hochleistungswerkstoffe wie NdFeB oder SmCo können galvanisch nicht abgeschieden werden. Aspekt-Verhältnisse größer 1:1 lassen sich so für Strukturen von 50 µm Durchmesser bzw. Kantenlänge nicht erreichen. Die Abscheidung über 100 µm dicker NdFeB-Schichten mittels Pulsed Laser Deposition (gepulste Laserabscheidung, PLD) wurde in [10] demonstriert. Ungelöst bleibt bei diesem Herstellungsverfahren jedoch die Mikrostrukturierung solcher Schichten. Alternativ können NdFeB-Mikromagnete durch Dispersion magnethaltiger Lösungen erzeugt werden [11], jedoch schwanken Form und Abmessungen dramatisch. Eine Alternative ist das Befüllen von Mikroformen in einem Si-Substrat mit losem Magnetpulver und dessen anschließende Fixierung, z. B. durch Beschichtung des Substrats mit Parylene [12]. Aufgrund der begrenzten thermischen Stabilität organischer Materialien sowie des unzureichenden Schutzes der Magnetpartikel vor Korrosion ist die Weiterbearbeitung solcher Substrate erheblich eingeschränkt.

Weitere Ansätze sind aus dem Folgenden Stand der Technik bekannt:
Die US2007209437A1 befasst sich mit magnetischen mikroelektromechanischen Systemen (MEMS) oder magnetischen MEMS-Vorrichtungen, insbesondere elektronische Vorrichtungen, bei denen ein Element an eine Basis oder ein Substrat angrenzt und sich von dem Substrat nahe zu einem Magnetfeldelement erstreckt, das eine geänderte Ausgabe basierend auf einer Bewegung des Elements aufweist.

Die EP0306178A2 befasst sich mit Beschleunigungssensoren mit einem freitragenden Balken mit einem freien Ende, an dem ein Permanentmagnet befestigt ist. Ein Paar magnetischer Sensoren, die jeweils aus einem magnetoresistiven Sensorelement vom Barber-Pole-Typ bestehen, sind gegenüberliegend und symmetrisch in Bezug auf den Magneten angeordnet. Der Ausleger wird gebogen und der Magnet wird gemäß einer Beschleunigung bewegt, die als Ausgangssignale von den magnetoresistiven Erfassungselementen erfasst werden.

Jackson, Nathan & Pedrosa, Francisco & Bollero, Alberto & Mathewson, Alan & Olszewski, Oskar Z. (2016), "Integration of Thick-Film Permanent Magnets for MEMS Applications. Journal of Microelectromechanical Systems" 25. 1-9. 10.1109/JMEMS.2016.2574958, befasst sich mit einem Verfahren zum Integrieren dicker Permanentmagnetfilme in einen Mikrofabrikationsprozesse. Ein verbessertes Bindungsverfahren bestehend aus einem Hybrid aus Parylene N- und Parylene C-Dünnfilmen wurde in Verbindung mit verschiedenen Arten von NdFeB-Pulvern verwendet, um eingebettete Permanentmagnetfilme herzustellen.

Die WO2016005325A1 befasst sich mit einem Sensor, der eine starre Struktur, eine bewegliche Struktur, die relativ zu der starren Struktur bewegbar ist, einen Magneten, der ein Magnetfeld erzeugt, und ein erstes magnetsensitives Element, das dazu ausgestaltet ist, an seiner Position das Magnetfeld zu bestimmen, aufweist, wobei der Magnet an der starren Struktur befestigt ist und das erste magnetsensitive Element an der beweglichen Struktur befestigt ist, oder wobei der Magnet an der beweglichen Struktur befestigt ist und das erste magnetsensitive Element an der starren Struktur befestigt ist.

Die DE102017123431A1 befasst sich mit einem Drucksensor mit zumindest zwei Elektroden und einer integrierten Schaltung, die ausgebildet ist, um eine Kapazität zwischen den zumindest zwei Elektroden zu erfassen. Ferner umfasst der Drucksensor eine MEMS-Struktur, umfassend eine leitfähige oder dielektrische Membran, die ausgebildet ist, um sich abhängig von dem Druck relativ zu den zumindest zwei Elektroden zu bewegen.

Die DE102011010899A1 befasst sich mit einem Verfahren zum Erzeugen einer dreidimensionalen Struktur. Durch das Verfahren mit den Schritten: - Auf- oder Einbringen von Partikeln auf oder in ein Trägerelement, wobei zwischen den Partikeln eine Vielzahl von zumindest teilweise miteinander verbundener Hohlräume gebildet wird und wobei die Partikel an Berührungspunkten miteinander in Kontakt treten, - Verbinden der Partikel an den Berührungspunkten durch Beschichten der Anordnung aus Partikeln und Trägerelement, wobei die Hohlräume zumindest teilweise von der beim Beschichten erzeugten Schicht durchdrungen werden, können dreidimensionaler Strukturen mit geringem Aufwand hergestellt werden.

Die DE102016215616A1 befasst sich mit einer Vorrichtung sowie einem Verfahren zum Herstellen einer Vorrichtung, wobei das Verfahren unter anderem ein Bereitstellen eines Substrats und Erzeugen von mindestens zwei voneinander beabstandeten Kavitäten in dem Substrat aufweist. Jede Kavität weist ein Aspektverhältnis von mindestens 6:1 bei einer Tiefe von mindestens 50 µm auf. Die Kavitäten werden mit magnetischen Partikeln aufgefüllt, wobei die magnetischen Partikel an Berührungspunkten miteinander in Kontakt treten und zwischen den Berührungspunkten Hohlräume gebildet werden. Zumindest ein Teil der magnetischen Partikel wird an deren Berührungspunkten miteinander verbunden, und zwar durch Beschichten der magnetischen Partikel, wobei die Hohlräume zumindest teilweise von der beim Beschichten erzeugten Schicht durchdrungen werden, so dass die verbundenen magnetischen Partikel eine magnetische poröse Struktur bilden.

Wünschenswert wären präzise und einfach herzustellende Mikrosysteme, die eine präzise Positionsüberwachung großer Stellwege ermöglicht.

Die Aufgabe der vorliegenden Erfindung besteht deshalb darin, ein Mikrosystem und ein Verfahren zum Herstellen eines Mikrosystems bereitzustellen, das eine präzise und einfache Herstellung ermöglicht und im späteren Betrieb eine präzise Positionsüberwachung großer Stellwege ermöglicht.

Diese Aufgabe wird durch den Gegenstand der unabhängigen Patentansprüche gelöst.

Ein Kerngedanke der vorliegenden Erfindung besteht darin, eine permanentmagnetische Einrichtung mit einem Trägerelement eines Mikrosystems mechanisch fest zu verbinden, was einfach und präzise möglich ist. Hierdurch wird eine präzise Positionsüberwachung großer Stellwege ermöglicht.

Gemäß einem Aspekt der vorliegenden Erfindung wird die permanentmagnetische Einrichtung durch eine Agglomeration magnetischer Partikel bereitgestellt. Die magnetischen Partikel können dabei beispielsweise mittels einer Atomlagenabscheidung zu einer festen Struktur verbunden sein, wobei die feste Struktur gleichzeitig unter Verwendung der Beschichtung mit dem Trägerelement mechanisch fest verbunden werden kann. Bereiche oder Kavitäten können in Trägersubstraten präzise hergestellt werden, womit auch ein mittels Partikel gefülltes Volumen präzise einstellbar ist und so auch ein Volumen mit einer permanentmagnetischen Einrichtung präzise einstellbar ist, ebenso wie eine Geometrie und ein Aspekt-Verhältnis. Durch eine nachfolgende Atomlagenabscheidung auf eingefüllte magnetische Partikel können präzise magnetische Strukturen einfach und reproduzierbar in Trägerelemente eingefügt oder an diesen angeordnet werden.

Das Mikrosystem ist dabei dadurch gekennzeichnet, dass die Sensoreinrichtung zumindest ein Sensorelement aufweist, wobei jedes Sensorelement ausgebildet ist, um ein zugeordnetes Messsignal bereitzustellen und wobei die Sensoreinrichtung ausgebildet ist, um Störeinflüsse auf das zumindest eine Sensorelement zumindest teilweise zu korrigieren.

Gemäß einem Ausführungsbeispiel umfasst ein Verfahren zum Herstellen eines Mikrosystems ein Anordnen eines ersten Trägerelements und eines zweiten Trägerelements, sodass eine relative Lage des ersten Trägerelements und des zweiten Trägerelements zueinander veränderlich ist. Das Verfahren umfasst ein Verbinden einer magnetischen Einrichtung, die ausgebildet ist, um ein Magnetfeld zu erzeugen, mechanisch fest mit dem ersten Trägerelement. Das Verfahren umfasst ein Verbinden einer Sensoreinrichtung, die ausgebildet ist, um das Magnetfeld zu erfassen und um ein Sensorsignal bereitzustellen, das auf dem Magnetfeld basiert. Die Sensoreinrichtung wird mechanisch fest mit dem zweiten Trägerelement verbunden, wobei die Sensoreinrichtung zumindest ein Sensorelement aufweist, wobei jedes Sensorelement ausgebildet ist, um ein zugeordnetes Messsignal bereitzustellen und wobei die Sensoreinrichtung ausgebildet ist, um Störeinflüsse auf das zumindest eine Sensorelement zumindest teilweise zu korrigieren. Das Verfahren wird so ausgeführt, dass das Sensorsignal die relative Lage der Trägerelemente zueinander anzeigt.

Die vorliegende Erfindung stellt also ein Mikrosystem gemäß Anspruch 1 und ein Verfahren zum Herstellen eines Mikrosystems gemäß Anspruch 14 bereit.

Bevorzugte Ausführungsbeispiele der vorliegenden Erfindung sind in weiteren abhängigen Patentansprüchen definiert.

Alle Ausführungsformen und Beispiele der Beschreibung, die nicht in den Geltungsbereich der Ansprüche fallen, sind nicht Bestandteil der Erfindung und dienen lediglich der Veranschaulichung.

Ausführungsbeispiele der vorliegenden Erfindung werden unter Bezugnahme auf die beiliegenden Zeichnungen erläutert. Es zeigen:
- Fig. 1: einen beispielhaften simulierten Verlauf einer axialen magnetischen Flussdichte B_{z} eines durch Agglomeration von NdFeB(Neodym-Eisen-Bor)-Pulver hergestellten Mikromagneten gemäß einem Ausführungsbeispiel;
- Fig. 2: eine schematische Seitenansicht eines Mikrosystems gemäß einem Beispiel;
- Fig. 3a: eine schematische perspektivische Ansicht eines Mikrosystems gemäß einem Beispiel, das beispielhaft vier Permanentmagnete aufweist;
- Fig. 3b: eine schematische Seitenschnittansicht eines Teils eines Mikrosystems gemäß einem Beispiel;
- Fig. 4a-b: Simulationsergebnisse zur Darstellung eines Einflusses von erfindungsgemäßen Mikromagneten auf einen einzelnen Hall-Sensor;
- Fig. 5a-b: zu Fig. 4a-b vergleichbare Darstellungen mit erhöhtem Abstand zwischen den Mikromagneten und dem Hall-Sensor;
- Fig. 6a-b: schematische Graphen eines Verlaufs eines Magnetfelds beispielhaft für ein Sensorelement gemäß einem Ausführungsbeispiel;
- Fig. 7a: schematische Graphen von Magnetfeldern, die in unterschiedlichen Abständen zu dem Magneten erhalten werden können, gemäß einem Ausführungsbeispiel;
- Fig. 7b: eine schematische Aufsicht auf ein Trägerelement gemäß einem Ausführungsbeispiel;
- Fig. 8a: schematische Graphen von Verläufen von Signaländerungen in Abhängigkeit von der Größe der Magnete;
- Fig. 8b.: eine beispielhafte Tabelle mit möglichen Zahlenwerten eines Übersprechen (Cross Talk) bei der Verwendung erfindungsgemäßer Magnete;
- Fig. 9a: eine schematische Seitenschnittansicht eines Mikrosystems gemäß einem Beispiel, bei dem ein erstes Trägerelement gegenüber einem zweiten Trägerelement mittels einer Bewegung parallel zur z-Achse und/oder durch eine Rotation um die y-Achse beweglich angeordnet ist;
- Fig. 9b: eine schematische Seitenschnittansicht des Mikrosystems aus Fig. 9a in einer Konfiguration gemäß einem Beispiel, in welcher das erste Trägerelement alternativ oder zusätzlich zu den Erläuterungen der Fig. 9a für eine Bewegung parallel zur x-Achse und/oder für eine Bewegung als Rotation um eine Achse parallel zu der z-Achse ausgelegt ist;
- Fig. 10a: eine schematische Seitenschnittansicht eines Mikrosystems gemäß einem Beispiel, bei dem die permanentmagnetische Einrichtung beispielhaft einen einzelnen Permanentmagneten aufweist, während die Sensoreinrichtung eine hiervon verschiedene Anzahl von Sensorelementen aufweist;
- Fig. 10b: eine schematische Seitenschnittansicht eines gegenüber dem Mikrosystem aus Fig. 10a modifizierten Mikrosystems gemäß einem Beispiel, bei dem das zweite Trägerelement so geformt ist, dass es eine Vertiefung aufweist;
- Fig. 11: eine schematische Seitenschnittansicht eines Mikrosystems gemäß einem Ausführungsbeispiel, das zur Korrektur von Störeinflüssen ausgerichtet ist;
- Fig. 12: eine schematische Seitenschnittansicht eines Mikrosystems gemäß einem Ausführungsbeispiel mit einer Referenzmagnetfeldquelle;
- Fig. 13: ein schematisches Flussdiagramm eines Verfahrens gemäß einem Beispiel;
- Fig. 14a-b: beispielhafte Darstellungen von bekannten Konzepten zur kapazitiven Positionsdetektion unter Verwendung planarer oder kammartiger Elektrodenpaare;
- Fig. 15a: eine Darstellung eines bekannten magnetischen Linearmaßstabs; und
- Fig. 15b: eine Darstellung eines bekannten taktilen Sensors, bestehend aus einem Magneten der von einem Elastomer umschlossen ist.

Bevor nachfolgend Ausführungsbeispiele der vorliegenden Erfindung im Detail anhand der Zeichnungen näher erläutert werden, wird darauf hingewiesen, dass identische, funktionsgleiche oder gleichwirkende Elemente, Objekte und/oder Strukturen in den unterschiedlichen Figuren mit den gleichen Bezugszeichen versehen sind, so dass die in unterschiedlichen Ausführungsbeispielen dargestellte Beschreibung dieser Elemente untereinander austauschbar ist bzw. aufeinander angewendet werden kann.

Manche der nachfolgend beschriebenen Ausführungsbeispiele beziehen sich auf Mikrosysteme. Mikrosysteme bezeichnen dabei allgemein Systeme, die in geringen Maßstäben im Millimeter-Bereich, Mikrometer-Bereich oder gar Nanometer-Bereich hergestellt werden. Obwohl sich Halbleitermaterialien aufgrund der Fertigungsprozesse für solche Strukturen besonders eignen, sind die Ausführungsbeispiele nicht hierauf beschränkt, sodass alternativ oder zusätzlich zu Halbleitermaterialien und insbesondere MEMS-Prozessen (MEMS = mikroelektromechanisches System) auch andere Materialien wie Metallmaterialien oder anorganische Materialien wie Harze oder dergleichen verwendet werden können.

Manche der nachfolgend beschriebenen Ausführungsbeispiele beziehen sich auf Mikromagnete, die durch Agglomeration von Pulver mittels Atomlagenabscheidung (ALD) erzeugt werden. Derartige Verfahren sind beispielsweise in [13] oder [14] beschrieben. Die Erfinder haben herausgefunden, dass derartige Verfahren eine vielversprechende Lösung bieten, wenn sie auf magnetische Partikel, etwa umfassend NdFeB-Materialen, angewendet werden, also auf ein NdFeB-Pulver. Diese können beispielsweise auf Substrate, etwa umfassend ein Halbleitermaterial wie Silizium, aufgebracht werden und können ausgezeichnete magnetische Eigenschaften mit guter Reproduzierbarkeit ermöglichen. Die Erfinder haben herausgefunden, dass in der Substratebene beliebige Geometrien mit Strukturbreiten beispielsweise zwischen 25 µm und 2000 µm realisiert werden können. Eine Höhe der Mikromagnete kann beispielsweise bis zu 100 µm, 200 µm, 300 µm oder mehr betragen, beispielsweise bis zu 500 µm.

Ausführungsbeispiele nutzen das Magnetfeld von in der beweglichen Struktur integrierten Mikromagneten zur Positionsdetektion. In der beweglichen Struktur integriert bedeutet dabei, dass beispielsweise ein magnetisches Element in einer Vertiefung des Substrats angeordnet sein kann. Dies ist jedoch nicht zwingend erforderlich, da das Substrat nach einer Anordnung einer permanentmagnetischen Einrichtung noch verändert werden kann. So können beispielsweise in eine Vertiefung Partikel eingefügt werden, diese verfestigt werden und das Substrat nachträglich um die so erhaltene dreidimensionale Struktur entfernt werden, um die permanentmagnetische Einrichtung zumindest teilweise freizulegen. Bei einer Translation und/oder Verkippung der beweglichen Struktur verschiebt sich das von den integrierten Mikromagneten erzeugte Magnetfeld entsprechend. Das von einer Anordnung möglicherweise räumlich fixierter Magnetfeldsensoren detektierte Signal ändert sich entsprechend dieser Verschiebung des Magnetfelds und lässt somit den Rückschluss auf die Translation und/oder Verkippung der beweglichen Struktur zu.

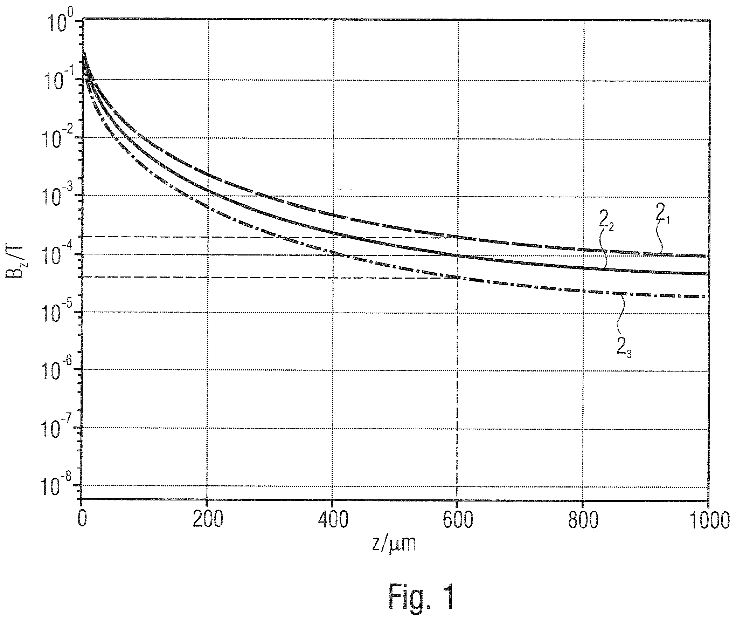

Fig. 1 zeigt einen beispielhaften simulierten Verlauf einer axialen magnetischen Flussdichte B_{z} eines durch Agglomeration von NdFeB(Neodym-Eisen-Bor)-Pulver hergestellten Mikromagneten in drei Varianten, wobei die Varianten jeweils einen Durchmesser d von 50 µm aufweisen, wobei sich der Durchmesser dabei auf eine Abmessung in der Substratebene bezieht, etwa ein Lochdurchmesser einer Kavität. Die Mikromagnete können unterschiedliche Längen aufweisen, was einer Tiefe der Kavität entsprechen kann. Der Verlauf 2₁ bezeichnet beispielhaft eine Länge von 250 µm, der Verlauf 2₂ eine Länge von 150 µm und der Verlauf 2₃ eine Länge von 50 µm. Es wird deutlich, dass selbst für den Verlauf 2₃ bei einem Abstand von 600 µm noch annähernd 0,1 mT an Magnetfeldstärke erreicht werden kann, bei tieferen Magneten sogar mehr. Die Zunahme der Flussdichte mit steigendem Aspekt-Verhältnis lässt ab einem Aspekt-Verhältnis von 5:1 stark nach, Feldstärken dieser Größenordnung sind jedoch mittels moderner Magnetfeldsensoren schon gut messbar. Arrays pulverbasierter Mikromagnete mit großem Aspekt-Verhältnis, hergestellt mittels des in [14] patentierten Verfahrens sind in [15] für die Erzeugung zweidimensionaler magnetischer Feldmuster für Anwendungen wie z. B. für Magnetmaßstäbe beschrieben.

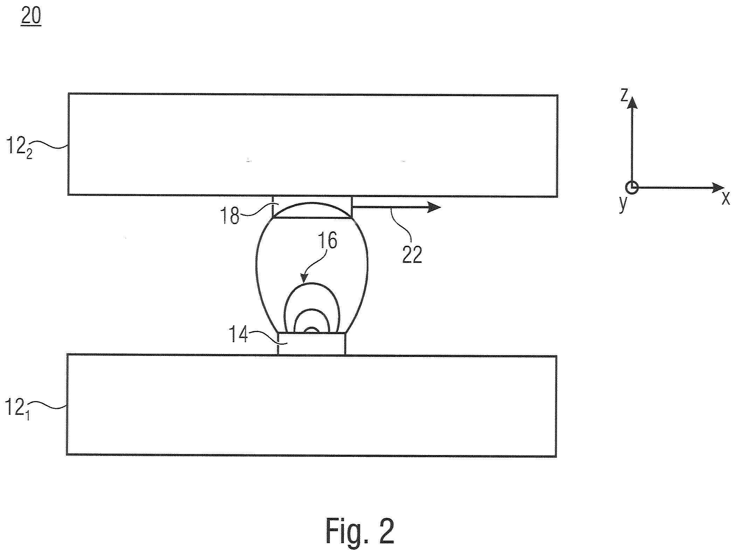

Fig. 2 zeigt eine schematische Seitenansicht eines Mikrosystems 20 gemäß einem Beispiel. Das Mikrosystem 20 umfasst Trägerelemente 12₁ und 12₂, die angeordnet sind, um eine relative Lage zueinander zu verändern. Dies kann durch Bewegung des Trägerelements 12₁ und/oder 12₂ entlang einer oder mehrerer Raumrichtungen x, y und/oder z erfolgen. Die Trägerelemente 12₁ und/oder 12₂ können gleiche oder voneinander verschiedene Materialien umfassen. Beispielsweise können die Trägerelemente 12₁ und/oder 12₂ ein Halbleitermaterial umfassen, wobei jedes der Trägerelemente 12₁ und/oder 12₂ auch eine Schichtfolge umfassen kann, in welcher sich ein Halbleitermaterial in dotiertem oder undotiertem Zustand mit anderen halbleiterbasierten Materialien, etwa Isolationsmaterialien wie SiO oder SiN oder dergleichen abwechselt und/oder in welchem leitende Materialen wie etwa Metallmaterialien angeordnet sind. Beispielhaft ist das Mikrosystem 20 ein MEMS. Die Trägerelemente können alternativ oder zusätzlich ein Glasmaterial oder ein Keramikmaterial umfassen, wobei hierunter auch Kombinationen dieser Materialien und/oder Kombinationen der Materialien mit anderen Materialien umfasst sind.

Beispielsweise ist das Trägerelement 12₁ ein bewegliches Trägerelement. Das Trägerelement 12₂ kann ein Substrat umfassen, so dass das Sensorsignal 22 eine Lage des beweglichen Trägerelements 12₁ gegenüber dem Substrat 12₂ anzeigt. Alternativ kann das Trägerelement 12₂ beweglich und das Trägerelement 12₁ ein Substrat sein und/oder es können beide Trägerelemente beweglich gegenüber einer dritten Struktur sein.

Das Mikrosystem 20 umfasst eine permanentmagnetische Einrichtung 14, die ausgebildet ist, basierend auf der permanentmagnetischen Eigenschaft ein Magnetfeld 16 zu erzeugen die permanentmagnetische Einrichtung kann mit dem Trägerelement 12₁ oder 12₂ fest verbunden sein, wobei eine mechanisch feste Verbindung bevorzugt ist. Eine mechanisch feste Verbindung kann als näherungsweise starre Verbindung zueinander aufgefasst werden. Beispielhaft kann die permanentmagnetische Einrichtung 14 mittels eines Abscheideverfahrens, eines Klebeverfahrens oder eines sonstigen Montageverfahrens angeordnet werden.

Bevorzugte Ausführungsbeispiele beziehen sich darauf, dass die permanentmagnetische Einrichtung 14 eine dreidimensionale Struktur ist, die mittels Verfestigung von Partikeln mittels einer Atomlagenabscheidung oder dergleichen erhalten wird. Diese Abscheidung einer Beschichtung der Partikel kann gleichzeitig genutzt werden, um eine feste Verbindung zwischen dem Trägerelement 12₁ und der permanentmagnetischen Einrichtung 14 zu erhalten.

Das Mikrosystem umfasst ferner eine Sensoreinrichtung 18, die mit dem anderen der Trägerelemente, etwa dem Trägerelement 12₂ mechanisch fest verbunden ist. Die mechanisch feste Verbindung zwischen der Sensoreinrichtung 18 und dem Trägerelement 12₂ kann basierend auf einem Montageprozess oder Klebeprozess erhalten werden. Die Sensoreinrichtung 18 ist ausgebildet, um das Magnetfeld 16 zu erfassen und um ein Sensorsignal 22 bereitzustellen, das auf dem Magnetfeld 16 basiert. Das Sensorsignal 22 zeigt eine relative Lage der Trägerelemente 12₁ und 12₂ an, da basierend auf einer veränderlichen relativen Lage eine Amplitude des von der Sensoreinrichtung 18 erfassten Magnetfeldes und/oder andere Eigenschaften, etwa Richtungskomponenten oder dergleichen, veränderlich sind. Ausgestaltungen ermöglichen es, dass das Sensorsignal 22 die relative Lage der Trägerelemente 12₁ und 12₂ relativ zueinander eindeutig angibt.

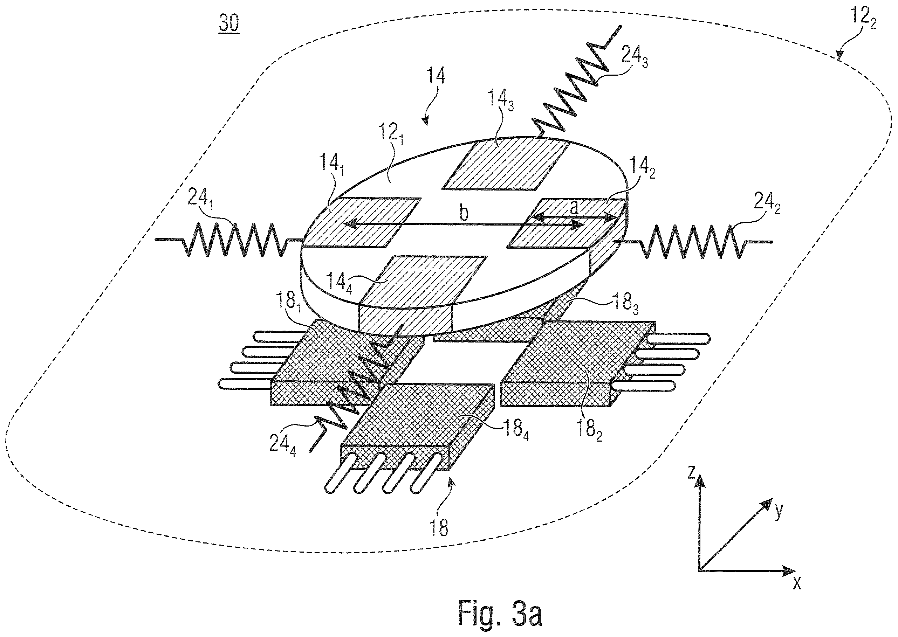

Fig. 3a zeigt eine schematische perspektivische Ansicht eines Mikrosystems 30 gemäß einem Beispiel. Die permanentmagnetische Einrichtung des Mikrosystems 30 kann beispielhaft vier Permanentmagnete 14₁ - 14₄ aufweisen. Das Trägerelement 12₁ kann beispielsweise als Kreisscheibe oder Zylinder gebildet sein, welcher über ein oder mehrere Federelemente 24₁ - 24₄ gegenüber dem Trägerelement 12₂ gehalten wird. Die Federelemente 24₁ - 24₄ können beispielsweise symmetrisch um das Trägerelement 12₁ angeordnet sein, wobei dies nicht erforderlich ist. Das Trägerelement 12₁ kann basierend auf den Federelementen 24₁ - 24₄ im Hinblick auf die relative Lage zu dem Trägerelement 12₂ beweglich sein, etwa basierend auf einer Rotation um eine oder mehrere der Achsen x, y oder z und/oder basierend auf einer lateralen Verschiebung entlang ein oder mehrerer dieser Achsen.

Die Federelemente 24₁ bis 24₄ können das Trägerelement 12₁ gegenüber dem Trägerelement 12₂ verbinden oder abstützen. Alternativ zu einer Anzahl von vier Federelementen kann auch eine andere Anzahl von größer 1 verwendet werden. Das zumindest eine Federelement kann eine bevorzugte Bewegungsrichtung zum Ändern der relativen Lage zwischen den Trägerelementen 12₁ und 12₂ vorgeben. So können beispielsweise Torsionsfederelemente eine Torsion vorgeben, während Biegeelemente entlang einer bevorzugten Biegerichtung deformierbar sind und entlang Richtungen senkrecht hierzu steif gebildet sind. Das Trägerelement 12₁ und/oder das Trägerelement 12₂ können beispielsweise als Plattenelement gebildet sein. Das Plattenelement kann beispielsweise einen Spiegel umfassen oder ein Spiegel sein. Es können jedoch auch beliebige andere Funktionen implementiert werden. Ausführungsbeispiele sehen Mikrosysteme vor, die als Scanner, elektrischer Schalter, optischer Schalter, als Ventil oder Pumpe gebildet sind.

Eine Richtung einer Änderung der relativen Lage kann auf zumindest einer Orientierung eines Federelements zwischen den Trägerelementen 12₁ und 12₂ basieren. Alternativ oder zusätzlich kann die Richtung der Änderung der relativen Lage auf zumindest einer Rotationsachse zum Ermöglichen einer Rotation des zumindest eines der Trägerelemente 12₁ und 12₂ basieren. Alternativ oder zusätzlich kann die Richtung einer Änderung der relativen Lage auf zumindest einer Begrenzungsfläche oder Begrenzungskante, entlang der eine Bewegung der Trägerelemente 12₁ und/oder 12₂ vorgegeben ist, basieren. Eine derartige Begrenzungsfläche oder Begrenzungskante kann beispielsweise ein mechanischer Anschlag sein.

Beispielsweise ist das Trägerelement 12₁ gegenüber dem Trägerelement 12₂ beispielhaft in der x-y-Ebene oder parallel hierzu beweglich. Die x/y-Ebene kann somit eine Ebene der Änderung der relativen Lage beschreiben. Zumindest eines, mehrere oder alle der permanentmagnetischen Elemente 14₁ bis 14₄ können bezüglich der Sensorelemente der Sensoreinrichtung 18 in dieser Ebene angeordnet sein. Bezüglich der Sensorelemente 18₁ bis 18₄ können die magnetischen Elemente 14₁ bis 14₄ senkrecht hierzu angeordnet sein, das bedeutet, entlang der senkrecht zu der x/y-Ebene angeordneten z-Richtung. In der Anordnung gemäß dem Mikrosystem 30 kann die permanentmagnetische Einrichtung 18 eine Anzahl von zumindest einem, beispielsweise vier permanentmagnetischen Elementen 14₁ bis 14₄ zum Erzeugen eines dem jeweiligen permanentmagnetischen Element 14₁ bis 14₄ zugeordneten Magnetfelds aufweisen. Die Sensoreinrichtung 18 kann eine korrespondierende Anzahl von Sensorelementen 18₁ bis 18₄ aufweisen. Beispielsweise kann jedem permanentmagnetischen Element 14₁ bis 14₄ exakt ein Sensorelement 18₁ bis 18₄ eindeutig zugeordnet sein. Dies erfolgt im Beispiel der Fig. 3a durch gegenüberliegende Anordnung von Permanentmagneten 14ᵢ und Sensorelement 18ᵢ mit i = 1,2,3,4. Dies ermöglicht, dass die Anzahl permanentmagnetischer Elemente 14 den Sensorelementen 18 in einer Ruhelage des Mikrosystems 30 spiegelsymmetrisch gegenüberliegend angeordnet sind, wobei eine Ebene parallel zur x/y-Ebene die Spiegelebene ist.

Beispielhaft sind die Permanentmagnete 14₁ - 14₄ in ein Material bzw. eine Struktur des Trägerelements 12₁ integriert, was beispielsweise dadurch erhalten werden kann, dass in dem Trägerelement 12₁ Kavitäten gebildet werden, welche mit magnetischen Partikeln verfüllt und anschließend durch einen Beschichtungsprozess verfestigt werden. Durch anschließende Planarisierung einer oder mehrerer Oberflächen kann eine homogene Oberflächenstruktur erhalten werden. Auch ohne die Planarisierung können ein oder mehrere Permanentmagnete 14₁ - 14₄, d. h. magnetische Elemente, in das Trägerelement 12₁ strukturell integriert sein.

Die Sensoreinrichtung 18 kann ein oder mehrere Sensorelemente 18₁ - 18₄ umfassen, die jeweils ausgebildet sind, um ein Messsignal bereitzustellen. Beispielsweise können die Sensorelemente 18₁ - 18₄ als Hall-Elemente zur Erfassung einer räumlichen Magnetfeldkomponente oder als Hall-Sensoren zur Erfassung mehrerer räumlicher Komponenten gebildet sein.

Beispielsweise kann jeweils ein Sensorelement 18₁ - 18₄ einem korrespondierenden Permanentmagneten 14₁ - 14₄ zugeordnet sein. Beispielhaft kann in einer Ruhelage des Mikrosystems 30 ein jeweiliger Permanentmagnet 14₁ - 14₄ bezogen auf ein zugeordnetes Sensorelement 18₁ - 18₄ eine Referenzposition aufweisen, beispielsweise zentriert hierzu angeordnet sein.

Basierend auf einer Verschiebung der relativen Lage zwischen den Trägerelementen 12₁ und 12₂ kann somit eine jeweilige Lage des Permanentmagneten 14₁ bis 14₄ bezüglich des Sensorelements 18₁ bis 18₄ verändert werden, so dass sich ein oder mehrere der Sensorsignale der Sensorelemente 18₁ bis 18₄ verändern können. So kann beispielsweise bei einer Rotation um die x-Achse ein Signal der Sensorelemente 18₁ und 18₂ näherungsweise konstant bleiben, während bei einer Rotation, beispielsweise um die y-Achse Sensorsignale der Sensorelemente 18₃ und 18₄ näherungsweise konstant bleiben können. Andere relative Lageveränderungen können zu anderen Veränderungen oder Unveränderlichkeiten in Sensorsignalen führen. Hierbei können auch mechanische Randbedingungen bezüglich der Veränderung der relativen Lage berücksichtigt werden. So können beispielsweise Permanentmagnete 14ᵢ mit i = 1,...., n mit n ≥ 1 so angeordnet werden, dass die mechanisch zulässigen oder vorgesehenen Änderungen der Relativbewegung erfasst werden können. Ist beispielsweise ausgehend von einer Endposition eine Bewegung lediglich entlang einer Richtung möglich, so kann bereits eine Anordnung eines einzelnen Permanentmagneten ausreichend sein. Ist eine Bewegung entlang einer Achse aber entlang zweier Richtungen möglich, so kann es bei Verwendung von lediglich einem Permanentmagneten zu Zweideutigkeiten in dem Messsignal kommen, was durch Anordnen eines zweiten Permanentmagneten/oder eines zweiten Sensorelements behoben werden kann. Zusätzliche Richtungen können durch zusätzliche Permanentmagnete und/oder Sensorelemente abgedeckt werden.

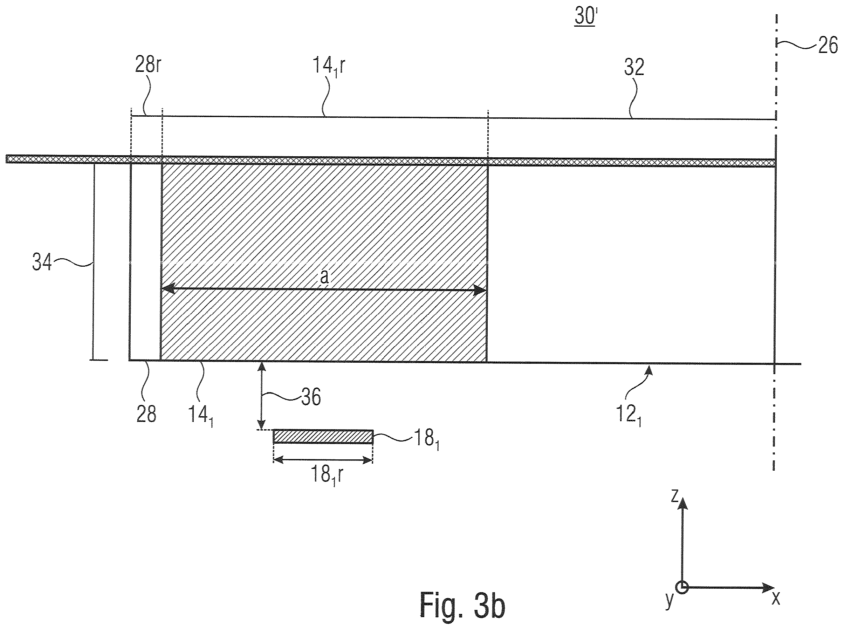

Fig. 3b zeigt eine schematische Seitenschnittansicht eines Teils eines Mikrosystems 30' gemäß einem Beispiel. Verglichen mit dem Mikrosystem 30 ist das Trägerelement 12₁ leicht verändert gebildet, beispielsweise so, dass entlang einer radialen Richtung, etwa entlang der negativen x-Richtung ausgehend von einer Symmetrieachse 26 das magnetische Element bzw. der Permanentmagnet 14₁ anders als in Fig. 3a, wo er einen äußeren Rand des Trägerelements 12₁ bilden kann, von einem äußeren Rand 28 umschlossen sein kann. Der äußere Rand 28 kann ein Trägermaterial oder Basismaterial des Trägerelements 12₁ aufweisen. Beispielsweise kann eine derartige Struktur dadurch erhalten werden, dass eine Kavität zum Befüllen mit den magnetischen Partikeln von dem Randbereich 28 umschlossen bleibt und beispielsweise nicht mittels eines Ätzprozesses oder dergleichen freigelegt wird oder die Kavität nicht an den Abschluss oder den Rand des Trägerelements 12₁ gelegt wird. Obwohl dies einen maximal möglichen Abstand zweier benachbarter oder gegenüberliegender Permanentmagnete reduzieren kann, ermöglicht dies Vorteile bei der Fertigung, etwa da das Material des äußeren Rands 28 einfacher zu bearbeiten ist als der Permanentmagnet 14₁. Eine Abmessung 28r des äußeren Rands 28 entlang der x-Richtung kann beispielsweise einen beliebig geringen Wert aufweisen, wobei Ausführungsbeispiele Maximalwerte von 100 µm, 75 µm oder 50 µm vorsehen. Eine Abmessung 14₁r bzw. eine Abmessung a des Permanentmagneten 14₁ entlang der radialen Richtung x kann einen beliebigen Wert aufweisen. Beispielsweise ist der Wert a so ausgestaltet, dass er zumindest 20 µm und höchstens 2000 µm, zumindest 100 µm und höchstens 1500 µm oder zumindest 500 µm und höchstens 1000 µm aufweist, beispielsweise 750 µm. Das bedeutet, dass die permanentmagnetische Einrichtung zumindest ein permanentmagnetisches Element umfassen kann, wobei das permanentmagnetische Element senkrecht zu einer Dickenrichtung z eine erste translatorische Abmessung, beispielsweise entlang x und eine zweite senkrechte translatorische Abmessung, beispielsweise y, aufweisen kann. Die erste translatorische Abmessung und/oder die zweite translatorische Abmessung kann einen Wert von zumindest 20 µm und höchstens 2000 µm aufweisen.

Ein Abstand 32 zwischen der Symmetrieachse 26 und einer der Symmetrieachse 26 zugewandten äußeren Kante des Permanentmagneten 14₁ kann ebenfalls einen beliebigen Wert aufweisen, der beispielsweise von der Applikation des Mikrosystems abhängen kann. Beispielhaft weist der Abstand 32 einen Wert von zumindest 50 µm und höchstens 5 mm, zumindest 100 µm und höchstens 3 mm oder zumindest 200 µm und höchstens 1 mm auf, beispielsweise 450 µm. Bei symmetrischer Ausbildung des Trägerelements 12₁ kann ein doppelter Wert des Abstands 32 einen Abstand oder eine Lücke zwischen zwei gegenüberliegenden Permanentmagneten beschreiben, beispielsweise den Permanentmagneten 14₁ und 14₂ des Mikrosystems 30.

Der Abstand 32 und die Abmessung a kann dabei so gewählt werden, dass ein Abstand der permanentmagnetischen Elemente zueinander so gewählt ist, dass eine Erfassung des magnetischen Felds eines permanentmagnetischen Elements am Ort eines hierzu zugeordneten Sensorelements von Feldern benachbarter permanentmagnetischer Elemente höchstens unwesentlich beeinflusst ist. Als eine unwesentliche Beeinflussung kann beispielsweise verstanden werden, dass das Magnetfeld eines permanentmagnetischen Elements verglichen mit einer Amplitude des Magnetfelds eines anderen permanentmagnetischen Elements am Ort des dem anderen permanentmagnetischen Elements zugeordneten Sensorelements höchstens 10%, höchstens 5% oder höchstens 2% beträgt. Das bedeutet, eine Magnetfeldamplitude des permanentmagnetischen Elements 14₁ beträgt beispielsweise am Ort der Sensorelemente 18₂, 18₃ oder 18₄ des Mikrosystems 30 höchstens 10%, höchstens 5% oder höchstens 2%. Dies kann über eine entsprechende Einstellung eines Abstands b erfolgen, welcher sich beispielsweise auf Mittelpunkte von Hauptseitenoberflächen der Permanentmagnete bezieht.

In der gezeigten Anordnung des Mikrosystems 30 ist der Abstand 32 zur Symmetrieachse und der doppelte Wert hiervon zum gegenüberliegenden permanentmagnetischen Element beispielsweise ein größerer Abstand als zu direkt benachbarten permanentmagnetischen Elementen 14₃ und 14₄. Der Abstand sowohl zum gegenüberliegenden als auch zu dem direkt benachbarten Permanentmagneten 14₂, 14₃ und 14₄ kann dabei so gewählt sein, dass jeder der Permanentmagnete 14₁ bis 14₄ zu jedem anderen Permanentmagneten, d. h., in jeder beliebigen Paarung einen Abstand aufweist, der zumindest 50 µm, zumindest 70 µm oder zumindest 100 µm beträgt. Alternativ oder zusätzlich kann der Abstand zumindest das Doppelte einer lateralen Abmessung des Permanentmagneten und des zur Paarbildung herangezogenen anderen Permanentmagneten entlang der jeweiligen Verbindungsrichtung betragen. Die Verbindungsrichtung ist beispielsweise zwischen den Permanentmagneten 14₁ und 14₂ entlang der x-Richtung angeordnet, zwischen den Permanentmagneten 14₃ und 14₄ entlang der y-Richtung und zwischen den Permanentmagneten 14₁ und 14₃ oder 14₁ und 14₄ entlang einer Diagonalrichtung. Der Abstand kann somit beispielsweise dem doppelten Wert von a entsprechen.

Das Sensorelement 18₁ kann entlang der radialen Richtung x eine Ausdehnung oder Abmessung 18₁r aufweisen, die geringer sein kann als die Abmessung a, wobei auch andere Ausführungsbeispiele möglich sind. Beispielhaft beträgt die Abmessung 18₁r einen Wert von zumindest 1 µm und höchstens 300 µm, höchstens 200 µm oder höchstens 170 µm, beispielsweise etwa 150 µm. Obwohl manche Ausführungsbeispiele Abmessungen von zumindest 20 µm vorsehen, kann die Abmessung auch unterhalb 20 µm liegen. Bspw. können derart kleine Magnete einzeln oder in einer Mehrzahl oder Vielzahl verwendet werden, z. B. indem viele Sensorelemente im Array angeordnet werden. Ein solches Array kann als Verbund mehrerer Magnete betrachtet werden oder als ein einzelnes, kombinatorisches magnetisches Element.

Der Permanentmagnet 14₁ kann eine Dicke oder Länge, das bedeutet, eine Abmessung entlang der Richtung z senkrecht zu der axialen Richtung aufweisen, die als Dicke 34 bezeichnet ist und die beispielsweise einen Wert von zumindest 50 µm und höchstens 1000 µm, zumindest 100 µm und höchstens 700 µm oder zumindest 200 µm und höchstens 500 µm, beispielsweise 300 µm aufweisen kann.

Ein Abstand 36 zwischen einander zugewandten Oberflächen des Permanentmagneten 14₁ und des Sensorelements 18₁ kann in einer Ruhelage des Mikrosystems 30 oder 30' beispielsweise einen Wert von maximal 2000 µm, maximal 800 µm oder maximal 600 µm aufweisen und an die beabsichtigte oder tolerierbare Bewegung des Trägerelements 12₁ bezüglich des Trägerelements 12₂ angepasst sein. Das bedeutet, eine Auslegung der zu überwachenden Bewegungsamplitude bezüglich der Veränderung der relativen Lage kann berücksichtigt werden. Ein minimaler Abstand kann ebenfalls an die Bewegung angepasst sein und bspw. zumindest 10 µm, zumindest 70 µm oder zumindest 100 µm betragen. Das bedeutet, die Trägerelemente 12₁ und 12₂ können in einer Ruhelage des Mikrosystems einen Abstand 36 von zumindest 10 µm und höchstens 2000 µm aufweisen.

Benachbarte permanentmagnetische Elemente, beispielsweise 14₁ und 14₃ oder 14₁ und 14₄ können eine voneinander verschiedene Magnetfeldorientierung aufweisen. Beispielsweise können Nord-Pole einander benachbarter Permanentmagnete einander zugewandt sein oder alternativ Süd-Pole.

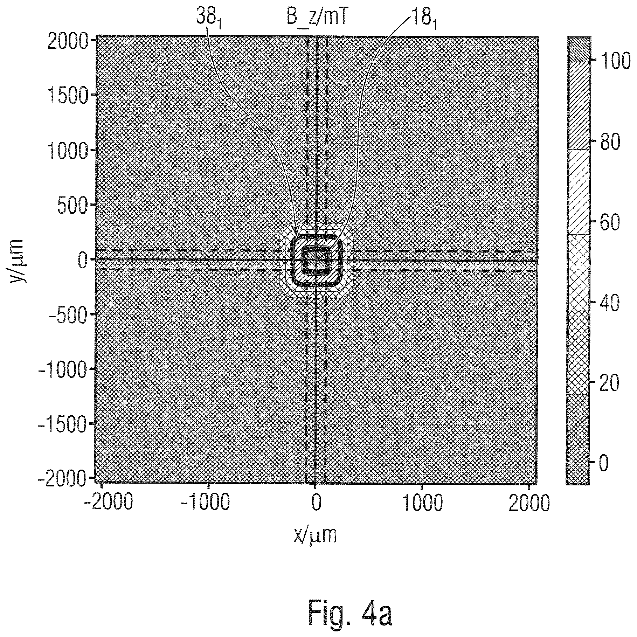

In anderen Worten zeigt Fig. 3a eine beispielhafte Anordnung bestehend aus einer beweglichen, federnd aufgehängten Plattform, zum Beispiel aus Silizium, mit vier integrierten Mikromagneten sowie vier darunter befindlichen, auf dem Untergrund fixierten Hall-Sensoren, schematisch dargestellt. Wichtige Abmessungen sind in der Querschnittszeichnung der Fig. 3b wiedergegeben. Die Plattform in dieser beispielhaften Anordnung kann einen Durchmesser von 2000 µm aufweisen und eine Höhe von 300 µm, das bedeutet, die Summe aus den Abständen 28r, 14₁r und 32 kann basierend auf der Symmetrie 1000 µm betragen, während die Abmessung 34 300 µm betragen kann. Die Kantenlänge a der möglicherweise quadratisch gebildeten Magnete kann an deren Ecken beispielsweise 500 µm betragen, der Abstand b von Mittelpunkt zu Mittelpunkt kann 1400 µm betragen. Die Magnete erstrecken sich über die volle Dicke der Plattform. Entlang des Plattform-Umfangs bleibt ein 50 µm breiter Si-Rand stehen. Dieser Si-Rand ist in Abbildung 4a nicht dargestellt. Die aktive Fläche der Hall-Sensoren kann beispielsweise 150 µm x 150 µm groß sein und beispielsweise mit den jeweiligen Magneten zentriert auf einer Achse liegen. Die Achse kann beispielhaft senkrecht zu einer Bewegungsebene angeordnet sein. Eine Bewegung, beispielsweise in der x/y-Ebene kann somit dazu dienen, eine entsprechende Achse entlang der z-Richtung bzw. parallel hierzu auszulegen, wie es in Fig. 3a dargestellt ist. Die Fig. 3a und 3b zeigen somit schematische Darstellungen einer Anordnung bestehend aus einer federnd aufgehängten Si-Plattform mit vier integrierten Mikromagneten sowie vier darunter befindlich, fest auf dem Untergrund fixierten Hall-Sensoren, wobei Fig. 3b einen möglicherweise maßstabsgerechten Querschnitt durch eine Plattformhälfte zeigt.

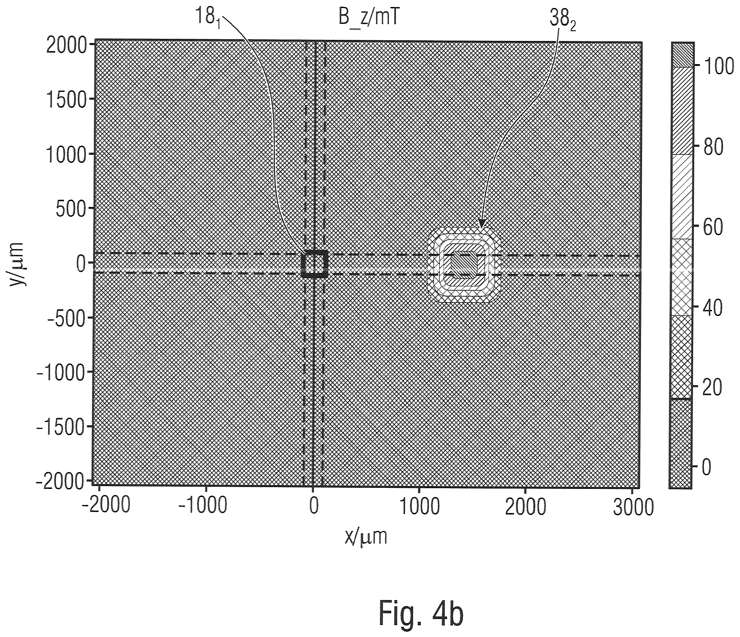

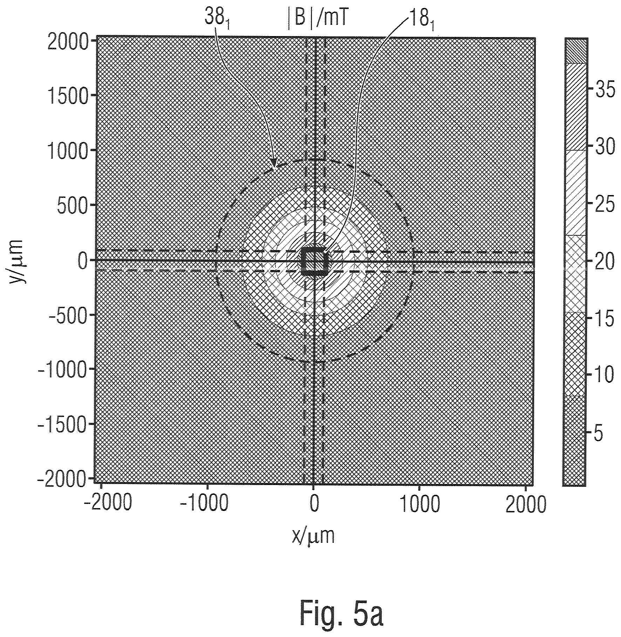

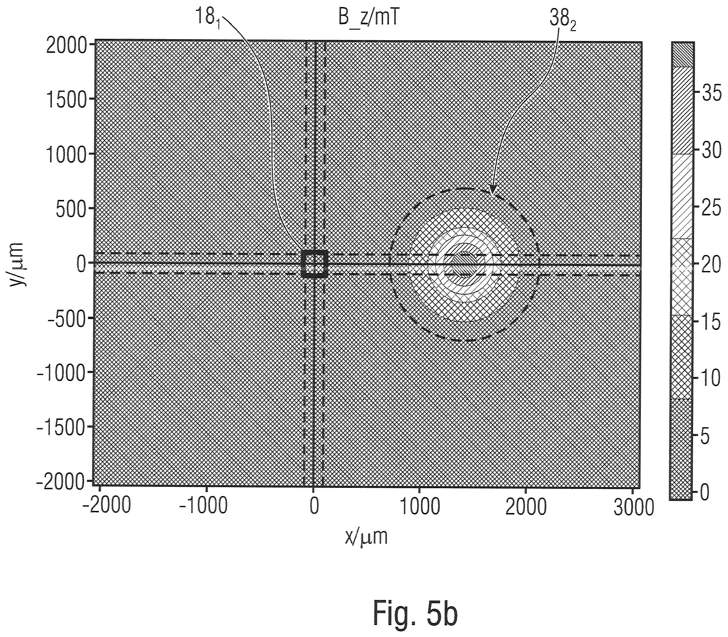

Fig. 4a und 4b illustrieren den Einfluss der Magnete, beispielsweise der Permanentmagnete 14₁ und 14₂ aus Fig. 3a auf einen einzelnen Hall-Sensor, beispielsweise das Sensorelement 18₁. Der Abstand 36 beträgt beispielhaft 100 µm. Der Magnet 14₁ kann ein starkes Magnetfeld erzeugen, dass seine Geometrie widerspiegelt und dessen Maximum den Hall-Sensor 18₁ nahezu vollständig überdeckt. Wie es in Fig. 4b gezeigt ist, fällt das Übersprechen (engl.: cross talk) des Magneten 14₂ auf den Hall-Sensor 18₁ hingegen gering aus. Dieser Zustand bleibt auch für einen Abstand 36 von 300 µm erhalten, wie es in den Fig. 5a und 5b gezeigt ist. Fig. 4a hingegen jedoch zeigt in einer schematischen Aufsicht eine Ausprägung eines Magnetfelds 38₁ des Permanentmagneten 14₁ am Ort des Sensorelements 18₁. Fig. 4b zeigt in derselben Perspektive wie Fig. 4a eine Ausprägung eines Magnetfelds 38₂ des Permanentmagneten 14₂, wobei deutlich wird, dass dieses Magnetfeld die Messung des Sensorelements 18₁ nicht oder höchstens unwesentlich beeinflusst.

Fig. 5a und Fig. 5b zeigen zu den Fig. 4a und 4b korrespondierende Darstellungen, bei denen der Abstand 36 auf 300 µm vergrößert ist. Eine Ausbreitung des Magnetfelds 38₁ bzw. 38₂ kann großflächiger sein, basierend auf den Abständen zwischen den Permanentmagneten 14₁ und 14₂ jedoch immer noch so gering, dass eine Messung des Sensorelements 18₁ von benachbarten Permanentmagneten 14₂ unbeeinflusst oder lediglich geringfügig beeinflusst ist.

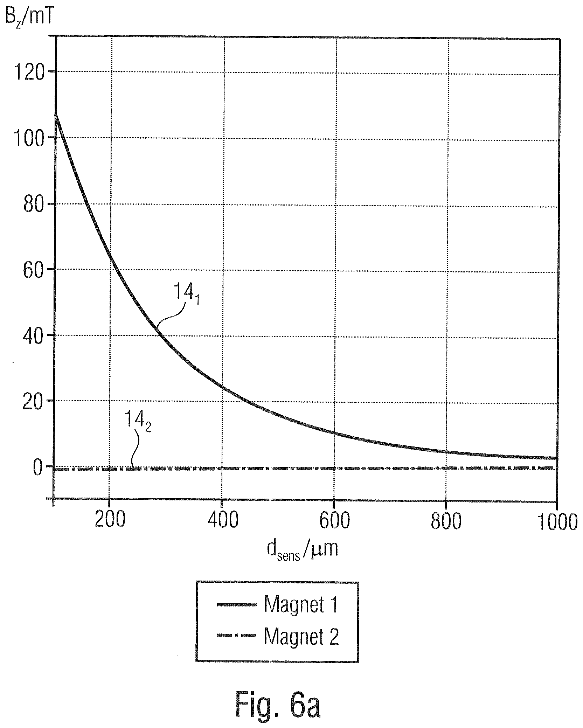

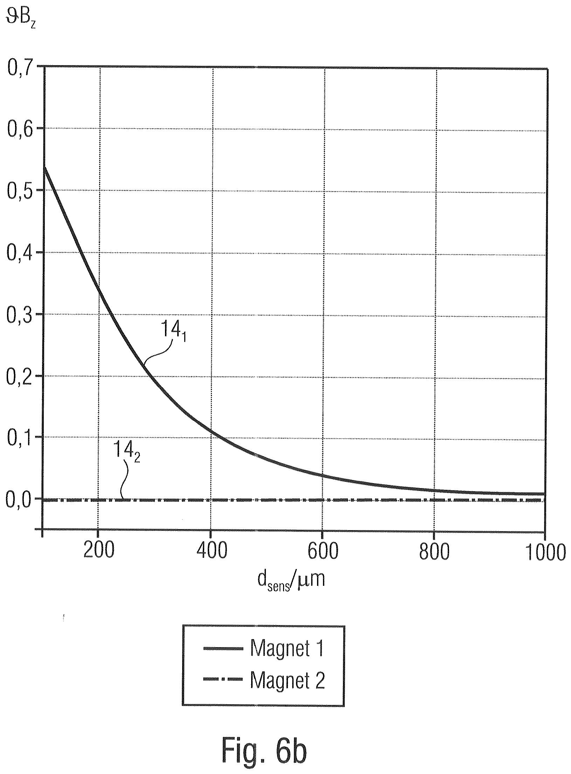

Fig. 6a und Fig. 6b zeigen schematische Graphen eines Verlaufs eines Magnetfelds B_{z}, beispielhaft für das Sensorelement 18₁. Mit zunehmenden Abstand dₛₑₙₛ, der beispielsweise in µm erfasst werden kann und dem Abstand 36 entsprechen kann, kann das Magnetfeld des Permanentmagneten 14₁ abnehmen, während das Magnetfeld des Magneten 14₂ bereits gering ist und konstant im Bereich eines Null-Werts bleiben kann.

Fig. 6b zeigt eine Ableitung der Kurven aus Fig. 6a, woraus ebenfalls ersichtlich ist, dass die Messwerte des Magnetfelds des Permanentmagneten 14₂ am Ort des Hall-Sensors 18₁ gering sind.

In anderen Worten präsentiert Fig. 6a die Abhängigkeit der magnetischen Flussdichte B_{z} vom Abstand dₛₑₙₛ zwischen der Sensorebene und der Unterseite der Magnete über einen Stellweg von 900 µm, wobei dₛₑₙₛ = 100 µm eine Ruhestellung des Mikrosystems repräsentieren kann. Das von dem Permanentmagneten 14₁ generierte Magnetfeld B_{z} bleibt in dieser Anordnung stets oberhalb von 3 mT. Gleichzeitig bleibt das Magnetfeld des Permanentmagneten 14₂ (Cross Talk) betragsmäßig stets unterhalb 5% des Magnetfelds des Permanentmagneten 14₁ bei gleichem Abstand. Für die magnetische Positionsdetektion ist insbesondere die Änderung des Magnetfelds in Abhängigkeit der zu detektierenden Positionsänderung ausschlaggebend oder beeinflussend. Der Absolutwert des Magnetfelds entscheidet an dieser Stelle beispielhaft nur über die Detektierbarkeit mittels der gewählten Magnetfeldsensoren und die Störanfälligkeit gegenüber Streufeldern aus der Umgebung. Für das hier gezeigte Beispiel wird in Fig. 6b die Magnetfeldänderung bei Verschiebung in z-Richtung dargestellt, entsprechend der Ableitung der in Fig. 6a gezeigten Kurven. Noch bei einem Abstand dₛₑₙₛ von 400 µm (d. h. 300 µm Stellweg) kann mit einer Empfindlichkeit besser als 0,1 mT/µm gerechnet werden.

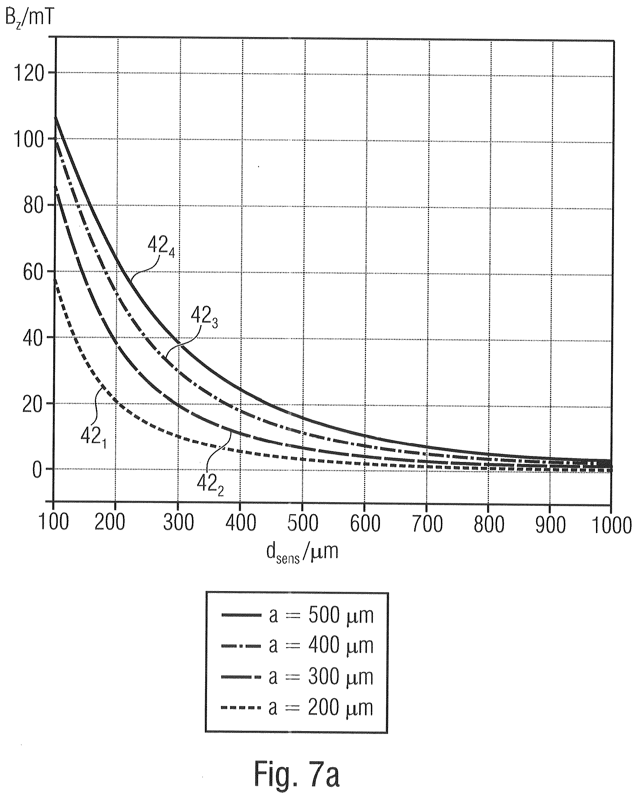

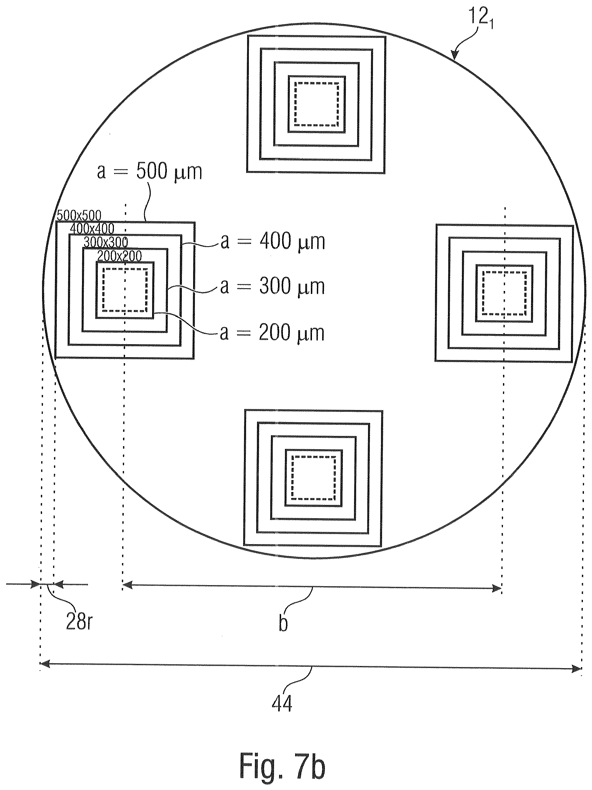

Fig. 7a zeigt schematische Graphen von Magnetfeldern, die in unterschiedlichen Abständen dₛₑₙₛ erhalten werden können. Die unterschiedlichen Kurven 42₁ bis 42₄ beziehen sich dabei auf voneinander verschiedene Kantenlängen beispielhaft quadratisch geformter Permanentmagnete 14₁ bis 14₄. Die Kurve 42₁ bezieht sich auf eine Kantenlänge von 200 µm, die Kurve 42₂ auf eine Kantenlänge von 300 µm, die Kurve 42₃ auf eine Kantenlänge von 4 µm und die Kurve 42₄ auf eine Kantenlänge von 500 µm. Wie es in Fig. 7b dargestellt ist, die eine beispielhafte schematische Aufsicht auf das Trägerelement 12₁ zeigt, kann der Abstand b von beispielhaft 1400 µm dabei unverändert bleiben, wobei hier geringere Abmessungen eine Vergrößerung des Rands 28r bedeuten können und/oder eine Verkleinerung des Gesamtdurchmessers 44, der beispielhaft 2000 µm betragen kann.

In anderen Worten zeigt Fig. 7a Verläufe der magnetischen Flussdichten B_{z} in Abhängigkeit von dₛₑₙₛ und der Kantenlänge a des Magneten in Fig. 7a sowie eine Draufsicht auf die Plattform gemäß Fig. 3a und 3b zur Illustration, wie die Magnete skaliert werden können, in Fig. 7b. Die Dicke der Magneten sowie der Abstand b vom Mittelpunkt zu Mittelpunkt der Magnete kann dabei beispielhaft gleich bleiben und beispielhaft 300 µm für die Dicke bzw. 1400 µm für den Abstand b betragen. In Fig. 7a ist dargestellt, wie der Verlauf von B_{z} von der Größe des Magneten abhängt. Die Magnete wurden jeweils zentrisch skaliert, so dass der Abstand b zwischen gegenüberliegenden Magneten (1400 µm) sowie die äußeren Abmessungen der Plattform gemäß Fig. 3a und Fig. 3b (2000 µm Durchmesser) konstant bleiben, wie es auch in Fig. 7b dargestellt ist.

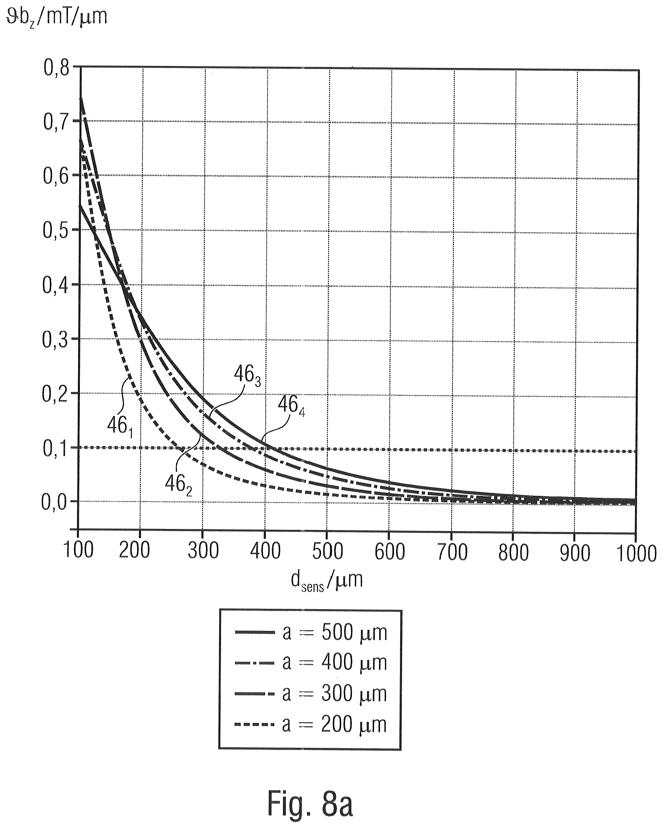

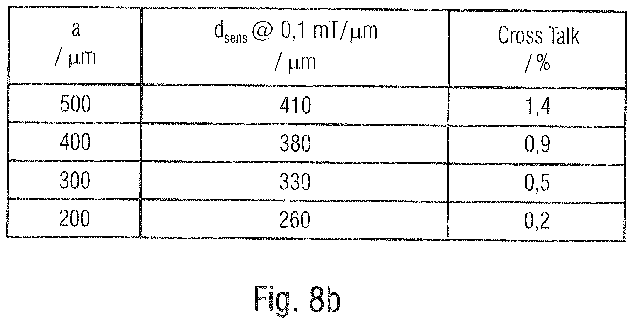

Die Fig. 8a zeigt schematische Graphen von Verläufen von Signaländerungen, das bedeutet der Ableitung von B_{z}, λB_{z}, in Abhängigkeit von der Größe der Magnete und gibt einen Überblick über die wichtigsten Ergebnisse der Simulation. Bei kleineren Stellwegen, d. h., dₛₑₙₛ > 100 µm, sind kleinere Magnete von Vorteil, da hier das Magnetfeld über eine kürzere Strecke abfällt und so eine höhere Sensitivität erreicht wird. Zudem nimmt das Übersprechen (Cross Talk) bei der Verwendung kleinerer Magnete ab, wie es in Fig. 8b dargestellt ist. Allerdings wird die Sensitivität mit abnehmender Magnetgröße zunehmend nicht-linear. Alternativ kann mit abnehmender Kantenlänge a der Abstand b zwischen den Magneten verringert werden. Bevorzugt sind daher Mikromagnete mit Kantenlängen zwischen 20 µm und 2000 µm und bevorzugt Mikromagnete mit Kantenlängen zwischen 500 µm und 1000 µm.

In Fig. 8a zeigt eine Kurve 46₁ die Ergebnisse für eine Kantenlänge von a = 200 µm, eine Kurve 46₂ ein Ergebnis für eine Kantenlänge von a = 300 µm, eine Kurve 46₃ ein Ergebnis für eine Kantenlänge von a = 400 µm und eine Kurve 46₄ ein Ergebnis für a = 500 µm. Die Kurven zeigen Verläufe der Signaländerungen, d. h., Ableitungen von B_{z}, in Abhängigkeit von dₛₑₙₛ und der Kantenlänge a des Magneten in Fig. 8a sowie eine Zusammenfassung der wichtigsten Ergebnisse der Simulation in Fig.8b.

Es hat sich herausgestellt, dass mittels der magnetischen Positionsdetektion komplexe Lageänderungen beweglicher MEMS-Strukturen über einen Stellbereich überwacht werden können, der im Vergleich zur kapazitiven oder piezoresistiven Positionsdetektion bei gleichem Platzbedarf um mindestens eine Größenordnung größer ist. Schon einfache, auf zwei Mikromagnet-Sensor-Paaren beruhende Ausführungen erlauben sowohl die Detektion von vertikalen Verschiebungen und Verkippungen, als auch die von lateralen Verschiebungen und Verdrehungen in der Ebene. Wie es im Zusammenhang mit den Fig. 3a und 3b beschrieben ist, können durch Verwendung von weitern Mikromagnet-Sensor-Paaren auf analoge Weise beliebige dreidimensionale Lageänderungen überwacht werden. Bei den dargestellten Ergebnissen der Fig. 4a, 4b, 5a, 5b, 6a, 6b, 7a, 7b, 8a und 8b wurden für die integrierten Magnete eine Magnetisierung von 450 mT angenommen, was durch ein beschriebenes agglomeriertes NdFeB-Pulver möglich ist. Alternativ oder zusätzlich können auch andere hartmagnetische Materialien verwendet werden. Hierzu gehären bspw. SmCo, PtCo, AlNiCo, CoFeNi, FeCrCo oder verschiedene Hart-Ferrite, sowie Kombinationen hieraus. Im Vergleich zur optischen Positionsdetektion ist die beschriebene magnetische Positionsdetektion kostengünstiger, unempfindlich gegenüber Verschmutzungen und erlaubt eine vergleichbar hohe Präzision.

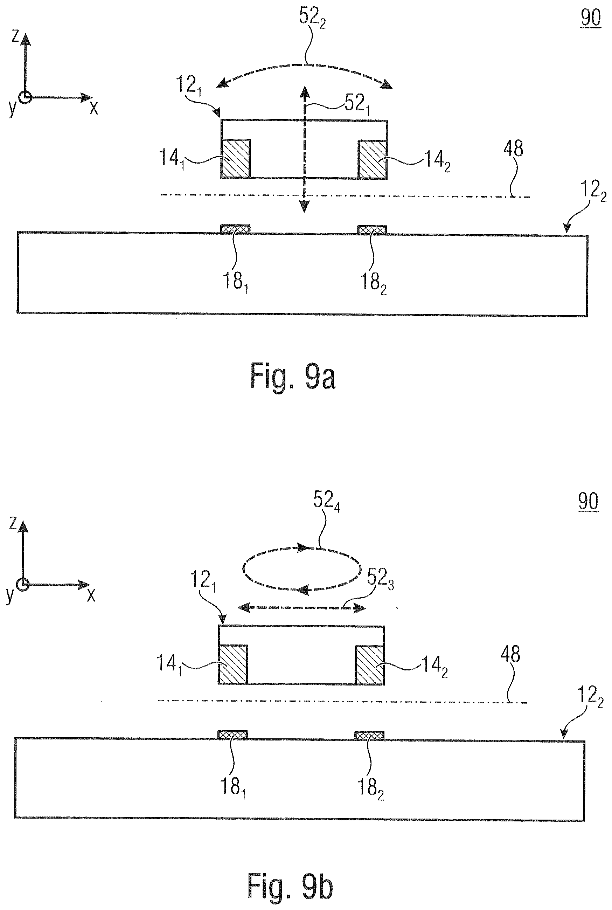

Fig. 9a zeigt eine schematische Seitenschnittansicht eines Mikrosystems 90 gemäß einem Beispiel, bei dem das Trägerelement 12₁ beispielhaft gegenüber dem Trägerelement 12₂ mittels einer Bewegung parallel zur z-Achse und/oder durch eine Rotation um die y-Achse beweglich angeordnet ist. Eine Anzahl von beispielhaft zwei Permanentmagneten 14₁ und 14₂ ist spiegelsymmetrisch zu einer Ebene 48, die parallel zur x/y-Ebene angeordnet ist, bezüglich Sensorelementen 18₁ und 18₂ angeordnet.

Während eine Bewegung 52₁ parallel zur z-Achse eine gleichsinnige Veränderung von Messwerten in den Sensorelementen 18₁ und 18₂ bewirken kann, kann eine um die y-Achse rotatorisch ausgerichtete Bewegung 52₂ zu einer gegensinnigen Veränderung der Messwerte führen. Das bedeutet, dass das Trägerelement 12₁ entlang zumindest einer Achse translatorisch gegenüber dem Trägerelement 12₂ relativ verschiebbar ist und/oder gegenüber dem Trägerelement 12₂ relativ verkippbar ist.

Fig. 9b zeigt eine schematische Seitenschnittansicht des Mikrosystems 90 in einer Konfiguration, in welcher das Trägerelement 12₁ alternativ oder zusätzlich zu den Erläuterungen der Fig. 9a für eine Bewegung 52₃ parallel zur x-Achse und/oder für eine Bewegung 52₄ als Rotation um eine Achse parallel zu der z-Achse ausgelegt ist. Beide Bewegungen 52₃ und 52₄ können zu einer gleichsinnigen Änderung von Messwerten in den Sensorelementen 18₁ und 18₂ führen, zumindest im Hinblick auf die Messamplitude.

Mit anderen Worten zeigen die Fig. 9a und 9b schematische Darstellungen möglicher Anordnungen zur Detektion vertikaler Verschiebungen und Verkippungen in Fig. 9a sowie laterale Verschiebungen und Verdrehungen in der Ebene in Fig. 9b unter Verwendung von zwei Mikromagnet-Sensor-Paaren 14₁/18₁ bzw. 14₂/18₂.

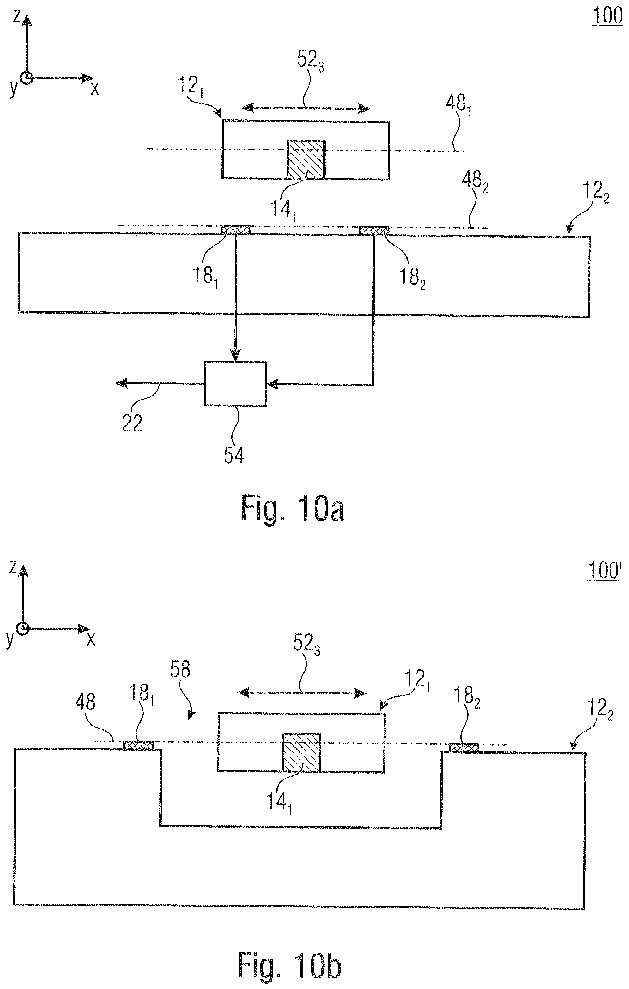

Fig. 10a zeigt eine schematische Seitenschnittansicht eines Mikrosystems 100 gemäß einem Beispiel, bei dem die permanentmagnetische Einrichtung beispielhaft einen einzelnen Permanentmagneten 14₁ aufweist, während die Sensoreinrichtung eine hiervon verschiedene Anzahl von Sensorelementen 18₁ und 18₂ aufweist. Die permanentmagnetische Einrichtung und/oder die Sensoreinrichtung können auch eine höhere Anzahl von Elementen aufweisen. In dem Ausführungsbeispiel der Fig. 10a ist dem permanentmagnetischen Element 14₁ das Sensorelement 18₁ und das Sensorelement 18₂, gegebenenfalls zusätzliche Sensorelemente zugeordnet. Das bedeutet, die Sensorelemente 18₁ und 18₂ sind räumlich benachbart zu dem Permanentmagneten 14₁ angeordnet, bevorzugte so, dass bei einer Bewegung der Trägerelemente 12₁ und 12₂ relativ zueinander in beiden Sensorelementen 18₁ und 18₂ ein deutliches Messsignal feststellbar ist. Die Sensoreinrichtung 18 kann eine Berechnungseinrichtung 54 aufweisen, beispielsweise ein applikationsspezifischer integrierter Schaltkreis (ASIC), ein Mikrocontroller, ein Prozessor oder dergleichen, die ausgebildet ist, um die Sensorelemente 18₁ und 18₂ differenziell auszuwerten, so dass das Sensorsignal 22 auf der differenziellen Auswertung des Magnetfelds des Permanentmagneten 14₁ durch Messung zumindest mit den Sensorwerten 18₁ und 18₂ basiert.

Das bedeutet, dass die Sensoreinrichtung 18 beispielsweise zumindest ein Sensorelement und die Auswerteschaltung 54 aufweist, die gemeinsam zumindest einen Teil einer anwendungsspezifischen integrierten Schaltung (ASIC) bilden.

Wie es im Zusammenhang mit dem Mikrosystem 30 oder 90 beschrieben ist, können die permanentmagnetische Einrichtung und die Sensoreinrichtung in unterschiedlichen Ebenen 48₁ und 48₂ angeordnet sein.

Fig. 10b zeigt eine schematische Seitenschnittansicht eines gegenüber dem Mikrosystem 100 modifizierten Mikrosystems 100'. Das Trägerelement 12₂ ist dabei so geformt, dass es eine Vertiefung oder Kavität 48 bereitstellt, was alternativ auch als Erhebungen benachbart zu dem Trägerelement 12₁ bezeichnet werden kann. Hierdurch kann eine Erhöhung für die Sensorelemente 18₁und 18₂ bereitgestellt werden, so dass die Sensoreinrichtung 18 bzw. die Sensorelemente 18₁ und 18₂ sowie die permanentmagnetische Einrichtung, insbesondere der Permanentmagnet 14₁ in einer gemeinsamen Ebene 48 angeordnet sind. Die Sensorelemente 18₁ und 18₂ können beide dem Permanentmagneten 14₁ zugeordnet sein.

Gemäß weiteren Ausführungsbeispielen umfasst ein Mikrosystem eine permanentmagnetische Einrichtung, die zumindest ein erstes permanentmagnetisches Element zum Erzeugen eines dem ersten permanentmagnetischen Element zugeordneten ersten Magnetfelds und ein zweites permanentmagnetisches Element zum Erzeugen eines dem zweiten permanentmagnetischen Element zugeordneten zweiten Magnetfelds. Die Sensoreinrichtung umfasst ein Sensorelement, dass sowohl dem ersten permanentmagnetischen Element als auch dem zweiten permanentmagnetischen Element zugeordnet ist, und ausgebildet ist, um eine Überlagerung des ersten Magnetfelds und des zweiten Magnetfelds zu erfassen. Das bedeutet, umgekehrt zur Erfassung eines einzelnen Magnetfelds mit mehreren Sensorelementen, können mehrere Magnetfelder mit einem gemeinsamen Sensorelement erfasst werden.

Diese Ausführungen sind beliebig miteinander kombinierbar, so dass unterschiedliche permanentmagnetische Elemente einem einzelnen Sensorelement zugeordnet sein können (Fig. 3a), mehreren Sensorelementen zugeordnet sein können (Fig. 10a und Fig. 10b) und andere permanentmagnetische Elemente durch mehrere Sensorelemente erfasst werden können.

Gemäß Ausführungsbeispielen weist die Sensoreinrichtung zumindest ein Sensorelement auf. Jedes Sensorelement der Sensoreinrichtung ist ausgebildet, um ein dem Sensorelement zugeordnetes Messsignal bereitzustellen, etwa ein Ausgangssignal des Hall-Sensors. Die Sensoreinrichtung kann ausgebildet sein, um Störeinflüsse auf das Sensorelement zumindest teilweise zu korrigieren.

In anderen Worten müssen Mikromagnet und Sensoren nicht zwingend paarweise verwendet werden. Fig. 10a und Fig. 10b zeigen zwei weitere Beispiel, in denen einem Mikromagneten 14₁ jeweils zwei Sensoren 18₁ und 18₂ zugeordnet sind. Dank dessen wird die Auswertung von Differenzsignalen möglich. Das erlaubt eine höhere Genauigkeit sowie die Eliminierung von Fehlerquellen.

Die Fig. 10a und 10b zeigen schematische Darstellungen möglicher Anordnungen zur Detektion lateraler Verschiebungen, wobei einem Mikromagneten 14₁ jeweils zwei Sensoren 18₁ und 18₂ zugeordnet sind, um Differenzmessungen zu ermöglichen. Bei der Anordnung gemäß Fig. 10a könnte der Mikromagnet senkrecht zur Ebene magnetisiert sein, also entlang der z-Richtung. Bei der Anordnung gemäß Fig. 10b könnte eine Magnetisierung in der Ebene, das bedeutet, in der x/y-Ebene vorteilhaft sein.

Je nach Anordnung können die Mikromagnete sowohl senkrecht zur Ebene als auch in der Ebene magnetisiert sein. Die gegenläufige Magnetisierung von Mikromagneten innerhalb einer Anordnung ist ebenfalls möglich. Zur Detektion können alle bekannten Magnetfeldsensoren, wie z. B. Hall-Sensoren, AMR-Sensoren (AMR = Anisotropic Magnetic Resistance, anisotroper Magnetwiderstand), GMR-Sensoren (GMR = Giant Magnetic Resistance, großer Magnetwiderstand) oder MAGFET (magnetischer Transistor) verwendet werden. Je nach Anordnung, Messzweck und Sensor kann dabei sowohl in der Ebene als auch senkrecht zur Ebene gemessen werden.

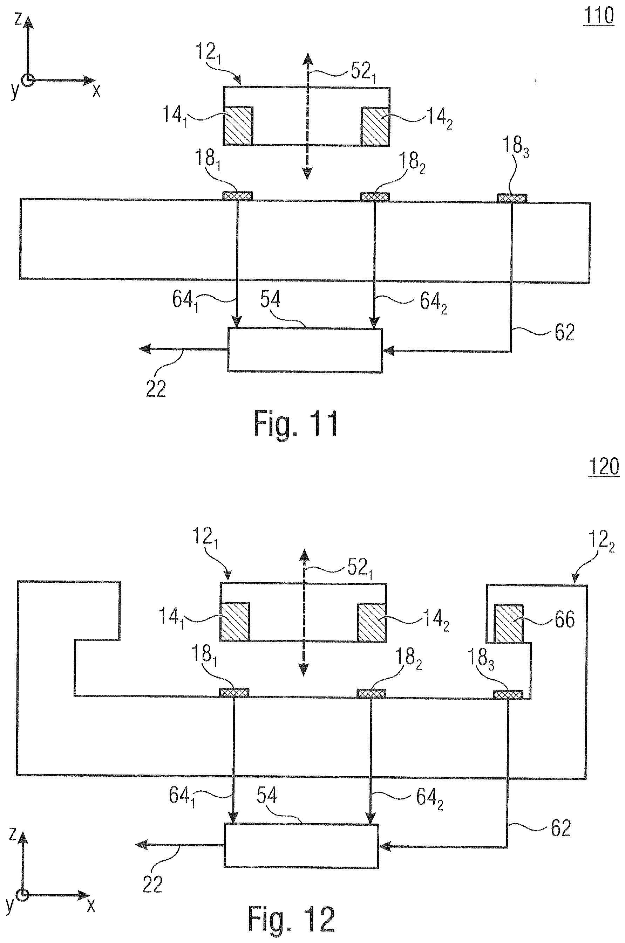

Fig. 11 zeigt eine schematische Seitenschnittansicht eines Mikrosystems 110 gemäß einem Ausführungsbeispiel, das zur Korrektur von Störeinflüssen ausgerichtet ist. Das Mikrosystem 110 ist beispielhaft eine Modifikation des Mikrosystems 100 und erweitert selbiges durch ein Referenzsensorelement 18₃ der Sensoreinrichtung. Das Referenzsensorelement 18₃ ist ausgebildet, um ein Referenzmagnetfeld zu erfassen und, um ein Referenzsignal 62 bereitzustellen. Die Sensoreinrichtung ist ausgebildet, um das Messsignal 64₁ des Sensorelements 18₁ und/oder das Messsignal 64₂ des Sensorelements 18₂ oder das Sensorsignal 22 oder eine Kombination hieraus unter Verwendung des Referenzsignals 62 anzupassen, um die Störeinflüsse, die möglicherweise auf die Sensorelemente 18₁ und/oder 18₂ wirken, zumindest teilweise zu korrigieren. Das Sensorelement 18₃ kann dabei beispielhaft außerhalb eines Magnetfelds der Permanentmagnete 14₁ und 14₂ angeordnet sein. Das Referenzmagnetfeld kann beispielsweise ein Umgebungsmagnetfeld des Mikrosystems sein, somit ein Umwelteinfluss.

In anderen Worten zeigt Fig. 11 eine Anordnung zur Kompensation von Drifteffekten bzw. der Erhöhung der Genauigkeit, beruhend auf der Nutzung von einem oder mehreren Referenzsensoren auf dem Trägerelement.

Fig. 12 zeigt eine schematische Seitenschnittansicht eines Mikrosystems 120 gemäß einem Ausführungsbeispiel. Verglichen mit dem Mikrosystem 110 weist diese eine Referenzmagnetquelle 66 auf. Dessen Referenzmagnetfeld überlagert sich mit einem Umgebungsmagnetfeld am Ort des Referenzsensors, so dass ein kombinatorisches Magnetfeld mit dem Referenzsensor erfassbar ist. Bevorzugt ist das Referenzmagnetfeld so ausgelegt, dass es bei regulärem Betrieb, etwa bei normalem Erdmagnetfeld, einen überwiegenden Anteil an dem gemessenen Magnetfeld aufweist, bspw. zumindest 50 %, zumindest 70 % oder zumindest 90 %.

Die Referenzmagnetquelle 66 kann beispielsweise Teil der Sensoreinrichtung sein und ausgebildet sein, um ein Referenzmagnetfeld, welches durch das Referenzsensorelement 18₃ erfasst wird, zu erzeugen. Dies ermöglicht beispielsweise alternativ oder zusätzlich zur Erfassung von Umwelteinflüssen eine Erfassung des Referenzmagnetfelds 66 als künstlich erzeugtes Magnetfeld. Beispielsweise kann der Referenzmagnet 66 ähnlich oder identisch gebildet sein wie die Permanentmagnete 14₁ und 14₂, so dass beispielsweise anhand des Referenzsignals 62 eine Degradierung oder Alterung des unbeweglichen Referenzmagneten 66 erfasst werden kann, was für die Signalauswertung der Messsignale 64₁ und 64₂ berücksichtigt werden kann. Es ist vorteilhaft, die Referenzmagnetquelle 66 und das Referenzsensorelement 18₃ bezüglich einer Relativposition zueinander zu fixieren, um zuverlässige Messergebnisse zu erhalten.

Das Mikrosystem 110 und das Mikrosystem 120 können so ausgeführt sein, dass das Referenzsignal 62 von einer Änderung der relativen Lage zwischen den Trägerelementen 12₁ und 12₂ ganz oder teilweise unbeeinflusst ist. So ist beispielsweise das Referenzsignal 62 im Wesentlichen unbeeinflusst, sofern es eine Änderung von höchstens 10%, höchstens 5% oder höchstens 2% erfährt, wenn die relative Lage zwischen den Trägerelementen 12₁ und 12₂ verändert wird.

Eine möglicherweise wichtige Grundanforderung an jedes Detektionsverfahren ist eine hohe bis maximale Unabhängigkeit von Umgebungseinflüssen. Abgesehen von Fertigungstoleranzen und intrinsischen Drifteffekten können beispielsweise Umgebungstemperatur und/oder elektromagnetische Streufelder, die das Sensorsignal erheblich beeinflussen können oder verfälschen können, störend sein. Durch Integration von zusätzlichen Referenz-Sensoren und/oder Referenz-Mikromagneten auf dem Trägerelement kann ein solcher Effekt minimiert werden. In der Ausführung gemäß Fig. 11 ist ein Referenzsensor 18₃ beabstandet auf dem Trägerelement 12₂ platziert, so dass dessen Signal nicht durch eine Lageänderung der Mikromagneten 14₁ und 14₂ auf der beweglichen Mikrostruktur 12₁ beeinflusst wird. In der Struktur gemäß Fig. 12 wird ein von der beweglichen Mikrostruktur beabstandetes Sensor-Mikromagnet-Referenzpaar 66/18₃ verwendet. Das hat den Vorteil, dass auch Drift- und Alterungseffekte der Mikromagnete kompensiert werden können. Die Abmessungen der Mikromagnete für Referenzmessung und Detektion können dabei unterschiedlich sein, was eine gleiche Abmessung nicht ausschließt.

In anderen Worten zeigt Fig. 12 eine Anordnung zur Kompensation von Drifteffekten bzw. der Erhöhung der Genauigkeit, beruhend auf der Nutzung von einem oder mehreren Sensor-Mikromagnet-Referenzpaaren auf dem Trägerelement.

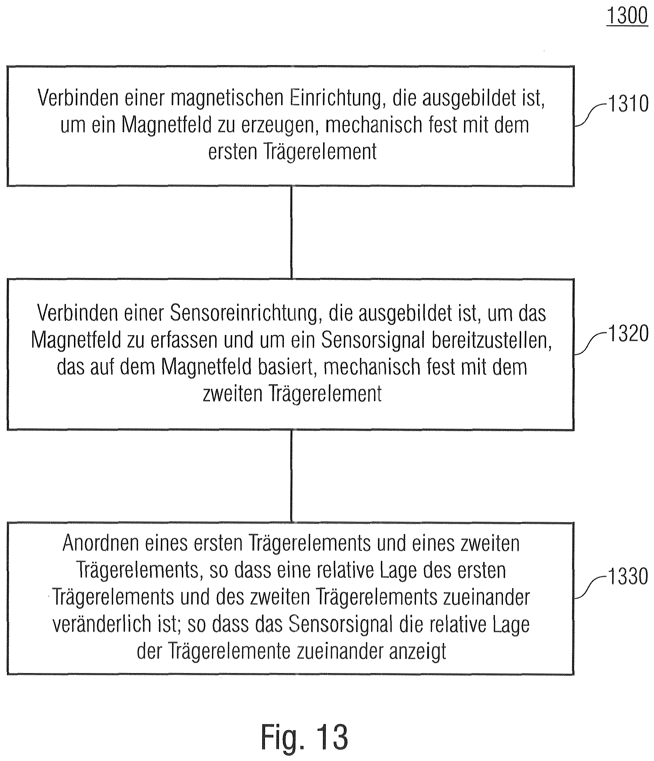

Fig. 13 zeigt ein schematisches Flussdiagramm eines Verfahrens 1300 gemäß einem Beispiel. In einem Schritt 1310 erfolgt ein Verbinden einer magnetischen Einrichtung, die ausgebildet ist, um ein Magnetfeld zu erzeugen, mechanisch fest mit dem ersten Trägerelement. In einem Schritt 1320. erfolgt ein Verbinden einer Sensoreinrichtung, die ausgebildet ist, um das Magnetfeld zu erfassen und um ein Sensorsignal bereitzustellen, dass auf dem Magnetfeld basiert, mechanisch fest mit einem zweiten Trägerelement. In einem Schritt 1330 erfolgt ein Anordnen des ersten Trägerelements und des zweiten Trägerelements, so dass eine relative Lage des ersten Trägerelements und des zweiten Trägerelements zueinander veränderlich ist. Das Verfahren wird so ausgeführt, dass das Sensorsignal die relative Lage der Trägerelemente zueinander anzeigt. Eine Reihenfolge der Schritte 1310, 1320 und 1330 kann daher beliebig sein. Es kann vorteilhaft sein, das Anordnen der Trägerelemente zueinander im letzten der genannten Schritte vorzunehmen, etwa durch Freilegen oder Freistellen oder Ätzen. Dies schließt nachfolgende Schritte nicht aus. Davor können, unabhängig voneinander da auf zwei verschiedenen Trägersubstraten, die magnetische Einrichtung mit dem ersten Trägerelement verbunden werden bzw. die Sensoreinrichtung mit dem zweiten Trägerelement verbunden werden. Alternativ könnte das erste Trägerelement z. B. mittels Oberflächen-Mikromechanik auf dem zweiten prozessieren und danach erst die Magnete im ersten Trägerelement realisieren. Das Freistellen des ersten Trägerelements wäre durch Herausätzen einer Opferschicht möglich. Es können ein oder mehrere Schritte in einem gemeinsamen Prozessschritt ausgeführt werden.

Das Verfahren kann dabei so ausgeführt werden, dass das Verbinden der permanentmagnetischen Einrichtung folgende Schritte umfasst: Erzeugen einer Aussparung in einem Bereich des Trägerelements 12₁; Einfüllen einer Vielzahl von magnetischen oder magnetisierbaren Mikropartikeln in die Aussparung; und Verfestigen der Anzahl von magnetischen oder magnetisierbaren Mikropartikeln mittels einer Atomlagenabscheidung. Nachfolgend kann optional eine Magnetisierung magnetisierbarer Mikropartikel erfolgen.

Die Anzahl der Mikromagnete und/oder Sensorelemente in vorangehend beschriebenen Ausführungsbeispielen ist beispielhaft gewählt. Es können beliebige andere Anzahlen von permanentmagnetischen Elementen und/oder Sensorelementen und/oder Referenzmagnetquellen und/oder Referenzsensorelementen gewählt werden.

Die dargestellten Ausführungsbeispiele ermöglichen im Vergleich zur kapazitiven und piezoresistiven Positionsdetektion eine Überwachung sehr viel größere Stellwege auf kleinstem Raum. Es können komplexe Trajektorien mit ein oder derselben Messanordnung überwacht werden. Es sind keine speziellen elektrischen Verbindungen zur beweglichen Mikrostruktur erforderlich, die magnetische Positionsdetektion kann berührungslos funktionieren und ist vom Antrieb entkoppelt. Es müssen keine zusätzlichen Kräfte aufgebracht werden. Die beschriebenen pulverbasierten Mikromagnete können sehr einfach in eine Mikrostruktur integriert werden. Durch die Verwendung von Referenzelementen, integriert auf demselben MEMS-Bauelement, können Messfehler, wie sie beispielsweise durch **Temperaturänderungen** oder elektromagnetische Streufelder verursacht werden, kompensiert werden.

Ausführungsbeispiele können unter anderem im Rahmen der magnetischen Positionsdetektion für die Überwachung von MEMS-Scannern oder Mikrospiegeln, für MEMS-Aperturplatten mit Mikrolinsen oder anderen optischen Elementen, für bewegliche Mikrostrukturen mit Strahlungsquellen und -Detektoren, für bewegliche Strukturen in MEMS-Bauelementen, die der Erzeugung, Regelung oder Überwachung fluidischer Ströme dienen (Pumpen, Ventile, Massenflusssensoren, Durchflussregler und dergleichen und/oder beweglichen Mikrostrukturen, die sich in einem abgekapselten Volumen bzw. System befinden) eingesetzt werden.

Mögliche Ausführungsbeispiele können auch so beschrieben werden:
- Anordnung, bestehend aus einer gegenüber einem starren Trägerelement beweglichen mikromechanischen Struktur mit
   ∘ einer Anordnung aus einem oder mehreren in der beweglichen mikromechanischen Struktur integrierten Mikromagneten,
   ∘ und einer Anordnung aus einem oder mehreren Magnetfeldsensoren auf dem starren Trägerelement,
   so dass eine Lageänderung oder Bewegung der mikromechanischen Struktur im Raum eine Änderung der Ausgangssignale der Magnetfeldsensoren hervorruft, die eindeutig mit dieser Lageänderung oder Bewegung korreliert ist.
- Die bewegliche mikromechanische Struktur kann
   ∘ federnd mit dem Trägerelement verbunden sein,
   ∘ aber auch völlig frei beweglich sein.
- Die bewegliche mikromechanische Struktur kann eine oder mehrere bevorzugte Bewegungsrichtungen bzw. Lageänderungen haben. Diese können vorgegeben sein
   ∘ durch Federelemente, die die bewegliche mikromechanische Struktur mit dem Trägersubstrat verbinden,
   ∘ durch eine Rotationsachse, um die sich die mikromechanische Struktur drehen kann,
   ∘ durch Begrenzungsflächen, auf denen sich die mikromechanische Struktur bewegen kann. Die bewegliche mikromechanische Struktur kann z. B. bedingt durch die Schwerkraft auf einer Oberfläche aufliegen, jedoch in der Ebene frei darüber gleiten können.
   o durch Begrenzungskanten, entlang derer sich die mikromechanische Struktur auf einer Fläche bewegen kann.
- Der Abstand zwischen der beweglichen mikromechanischen Struktur und dem starren Trägerelement im Ruhezustand liegt bevorzugt zwischen 50 µm und 2000 µm und besonders bevorzugt zwischen 100 µm und 500 µm.
- Die Kantenlänge eines einzelnen Mikromagneten liegt bevorzugt zwischen 20 µm bis 2000 µm und besonders bevorzugt zwischen 50 µm und 1000 µm.
- Der Abstand zwischen den Mikromagneten liegt bevorzugt zwischen 50 µm und 3000 µm und besonders bevorzugt zwischen 100 µm und 1000 µm.
- Anzahl und Lage der Mikromagnete auf der beweglichen mikromechanischen Struktur kann mit der Anzahl und Lage der Magnetfeldsensoren auf dem Trägerelement spiegelsymmetrisch übereinstimmen. Die Anordnungen können sich jedoch auch in Anzahl der Elemente und deren Position unterscheiden.
- Mikromagnete und Magnetfeldsensoren können sich paarweise gegenüberstehen. Es können jedoch auch einem Mikromagneten mehrere Magnetfeldsensoren bzw. mehrere Mikromagnete einem Magnetfeldsensor zugeordnet sein.
- Bevorzugt jedoch nicht ausschließlich sind benachbarte Mikromagnete auf der beweglichen mikromechanischen Struktur so voneinander beabstandet, dass das Streufeld eines Mikromagneten keinen der Magnetfeldsensoren beeinflusst, die anderen Mikromagneten zugeordnet sind.
- Ein Referenz-Magnetfeldsensor ist so auf dem Trägerelement platziert, dass er sich außerhalb des Streufelds der Mikromagnete auf der beweglichen mikromechanischen Struktur befindet.
- Dem Referenz-Magnetfeldsensor steht ein Referenz-Mikromagnet gegenüber, der im Trägerelement integriert ist. Der Referenz-Mikromagnet ist fest fixiert, d. h. seine Position relativ zum Referenz-Magnetfeldsensor verändert sich während der Bewegung der mikromechanischen Struktur nicht.
- Es können beliebige Magnetfeldsensoren verwendet werden, z. B. Hall, AMR, GMR, MAGFET. Im Falle eines Arrays können die Sensoren als einzelne Chips auf dem Trägerelement platziert werden. Insbesondere im Falle geringer Abstände zwischen den einzelnen Sensoren wird jedoch deren Integration in einer Schaltung auf einem Chip (ASIC), der mittels bekannter Halbleiterprozesse gefertigt werden kann, bevorzugt.
- Die Mikromagnete werden durch Agglomeration losen, µm-großen Pulvers eines magnetischen Materials mittels Atomlagenabscheidung (ALD) hergestellt.

Obwohl manche Aspekte im Zusammenhang mit einer Vorrichtung beschrieben wurden, versteht es sich, dass diese Aspekte auch eine Beschreibung des entsprechenden Verfahrens darstellen, sodass ein Block oder ein Bauelement einer Vorrichtung auch als ein entsprechender Verfahrensschritt oder als ein Merkmal eines Verfahrensschrittes zu verstehen ist. Analog dazu stellen Aspekte, die im Zusammenhang mit einem oder als ein Verfahrensschritt beschrieben wurden, auch eine Beschreibung eines entsprechenden Blocks oder Details oder Merkmals einer entsprechenden Vorrichtung dar.

Die oben beschriebenen Ausführungsbeispiele stellen lediglich eine Veranschaulichung der Prinzipien der vorliegenden Erfindung dar. Es versteht sich, dass Modifikationen und Variationen der hierin beschriebenen Anordnungen und Einzelheiten anderen Fachleuten einleuchten werden. Deshalb ist beabsichtigt, dass die Erfindung lediglich durch den Schutzumfang der nachstehenden Patentansprüche und nicht durch die spezifischen Einzelheiten, die anhand der Beschreibung und der Erläuterung der Ausführungsbeispiele hierin präsentiert wurden, beschränkt sei.

### Referenzen

[1] X. Liu et al., "A MEMS stage for 3-axis nanopositioning", J. Micromech. Microeng. 17, 2007
[2] A. Hung et al., "An electrostatically driven 2D micro-scanning mirror with capacitive sensing for projection display", Sensors and Actuators, A 222, 2015
[3] S. Lani et al., "2D MEMS scanner integrating a position feedback", MATEC, Web of Conferences 32, 01001, 2015
[4] B. Park et al., "Lorentz force based resonant MEMS magnetic-field sensor with optical readout", Sensors and Actuators A, 241, 2016
[5] X. Cheng et al., "Integrated optoelectronic position sensor for scanning micromirrors", Sensors, 18, 2018
[6] Bedienungsanleitung SCDplus Märzhäuser, Stand: 06.11.2009 Firmware v7.08
[7] UNI LEEDS Wang Design methodology for magnetic field-based soft tri-axis tactile sensors 2017
[8] Z.-H. Xu et. al., "Grooved multi-pole magnetic gratings for high-resolution positioning systems", Japanese Journal of Applied Physics 54, 2015
[9] C. Coutier et al., "A new magnetically actuated switch for precise position detection", Proc. IEEE Transducers Conf., Denver, CO, USA, 2009
[10] M. Nakano et al., "Nd-Fe-B Film magnets with thickness above 100 µm deposited on Si substrates", Transactions on Magnetics, Vol. 51, No. 11, 2015
[11] E. S. Leland et al., "A MEMS AC current sensor for residential and commercial electricity end-use monitoring", J. Micromech. Microeng., 19, 2009
[12] N. Jackson et al., "Integration of thick-film permanent magnets for MEMS applications", J. Microelectromech. Sys., Vol. 25, No. 4, 2016
[13] T. Lisec et al., "A Novel fabrication technique for MEMS based on agglomeration of powder by ALD", J. Microelectromech. Sys., Vol. 26, No. 5, 2017
[14] Patentschrift EP 2670880 B1, "Verfahren zum Erzeugen einer dreidimensionalen Struktur sowie dreidimensionale Struktur"
[15] Offenlegungsschrift DE 102016215616 A1, "Verfahren zum Herstellen einer magnetischen Struktur"

## Patentansprüche

1. Mikrosystem umfassend:
ein erstes Trägerelement (12₁) und ein zweites Trägerelement (12₂), wobei eine relative Lage des ersten Trägerelements (12₁) und des zweiten Trägerelements (12₂) zueinander veränderlich ist;
eine mit dem ersten Trägerelement (12₁) mechanisch fest verbundene permanentmagnetische Einrichtung (14), die ausgebildet ist, um ein Magnetfeld zu erzeugen;
eine mit dem zweiten Trägerelement (12₂) mechanisch fest verbundene Sensoreinrichtung (18), die ausgebildet ist, um das Magnetfeld zu erfassen und um ein Sensorsignal (22) bereitzustellen, das auf dem Magnetfeld basiert;
wobei das Sensorsignal (22) die relative Lage der Trägerelemente (12₁, 12₂) zueinander anzeigt;
**dadurch gekennzeichnet, dass**
die Sensoreinrichtung (18) zumindest ein Sensorelement (18₁-18₄) aufweist, wobei jedes Sensorelement (18₁-18₄) ausgebildet ist, um ein zugeordnetes Messsignal (64) bereitzustellen und wobei die Sensoreinrichtung (18) ausgebildet ist, um Störeinflüsse auf das zumindest eine Sensorelement (18₁-18₄) zumindest teilweise zu korrigieren.

2. Mikrosystem gemäß Anspruch 1, bei der die permanentmagnetische Einrichtung (14) zumindest ein permanentmagnetisches Element (14₁) mit einer Vielzahl miteinander mittels einer Beschichtung zu einer festen dreidimensionalen Struktur verbundener Partikel umfasst.

3. Mikrosystem gemäß Anspruch 1 oder 2 , bei der die permanentmagnetische Einrichtung (14) zumindest ein permanentmagnetisches Element (14₁) umfasst, das in das erste Trägerelement (12₁) strukturell integriert ist.

4. Mikrosystem gemäß einem der vorangehenden Ansprüche, bei dem die permanentmagnetische Einrichtung (14) eine Anzahl von zumindest einem permanentmagnetischen Element (14₁-14₄) zum Erzeugen eines dem permanentmagnetischen Element (14₁-14₄) zugeordneten Magnetfeldes umfasst; wobei die Sensoreinrichtung (18) eine Anzahl von Sensorelementen (18₁-18₄) aufweist, wobei jedem permanentmagnetischen Element (14₁-14₄) der Anzahl permanentmagnetischer Elemente zumindest ein erstes und ein zweites Sensorelement (18₁-18₄) zugeordnet ist, wobei die Sensoreinrichtung (18) ausgebildet ist, um das Sensorsignal (22) basierend auf einer zumindest differentiellen Auswertung des Magnetfeldes durch Messung zumindest mit dem ersten Sensorelement (18) und dem zweiten Sensorelement (18₂) bereitzustellen.

5. Mikrosystem gemäß einem der vorangehenden Ansprüche, bei dem die permanentmagnetische Einrichtung (14) ein erstes permanentmagnetisches Element zum Erzeugen eines dem ersten permanentmagnetischen Element zugeordneten ersten Magnetfeldes und ein zweites permanentmagnetisches Element zum Erzeugen eines dem zweiten permanentmagnetischen Element zugeordneten zweiten Magnetfeldes umfasst; wobei die Sensoreinrichtung (18) ein Sensorelement aufweist, das dem ersten permanentmagnetischen Element und dem zweiten permanentmagnetischen Element zugeordnet ist, und ausgebildet ist, um eine Überlagerung des ersten Magnetfeldes und des zweiten Magnetfeldes zu erfassen.

6. Mikrosystem gemäß einem der vorangehenden Ansprüche, bei dem die Sensoreinrichtung (18) ein Referenzsensorelement (18₃) aufweist, das ausgebildet ist, um ein Referenzmagnetfeld zu erfassen und ein Referenzsignal (62) bereitzustellen, wobei die Sensoreinrichtung (18) ausgebildet ist, um das Messsignal (64) oder das Sensorsignal (22) unter Verwendung des Referenzsignals (62) anzupassen, um die Störeinflüsse zumindest teilweise zu korrigieren.

7. Mikrosystem gemäß Anspruch 6, bei dem das Referenzmagnetfeld ein Umgebungsmagnetfeld des Mikrosystems ist.

8. Mikrosystem gemäß Anspruch 6, bei dem die Sensoreinrichtung eine Referenzmagnetquelle (66) umfasst, die ausgebildet ist, um das Referenzmagnetfeld zu erzeugen.

9. Mikrosystem gemäß Anspruch 8, bei dem eine Relativposition zwischen der Referenzmagnetquelle (66) und dem Referenzsensorelement (18₃) fixiert ist.

10. Mikrosystem gemäß einem der Ansprüche 6 bis 9, bei dem das Referenzsignal (62) von einer Änderung der relativen Lage im Wesentlichen unbeeinflusst ist.

11. Mikrosystem gemäß einem der vorangehenden Ansprüche, bei dem das erste Trägerelement (12₁) entlang zumindest einer Achse translatorisch gegenüber dem zweiten Trägerelement (12₂) relativ verschiebbar ist und/oder gegenüber dem zweiten Trägerelement (12₂) relativ verkippbar ist.

12. Mikrosystem gemäß einem der vorangehenden Ansprüche, bei der das erste Trägerelement (12₁) oder das zweite Trägerelement (12₂) als Plattenelement gebildet ist.

13. Mikrosystem gemäß einem der vorangehenden Ansprüche, bei dem eine Richtung einer Änderung der relativen Lage auf
zumindest einer Orientierung eines Federelements (24₁) zwischen dem ersten Trägerelement (12₁) und dem zweiten Trägerelement (12₂); oder
zumindest einer Rotationsachse zum Ermöglichen einer Rotation des ersten Trägerelements (12₁) oder des zweiten Trägerelements (12₂); oder
zumindest einer Begrenzungsfläche oder Begrenzungskante, entlang der eine Bewegung des ersten Trägerelements und/oder des zweiten Trägerelements vorgegeben ist;
basiert.

14. Verfahren (1300) zum Herstellen eines Mikrosystems mit folgenden Schritten:
Verbinden (1310) einer permanentmagnetischen Einrichtung, die ausgebildet ist, um ein Magnetfeld zu erzeugen, mechanisch fest mit dem ersten Trägerelement;
Verbinden (1320) einer Sensoreinrichtung, die ausgebildet ist, um das Magnetfeld zu erfassen und um ein Sensorsignal bereitzustellen, das auf dem Magnetfeld basiert, mechanisch fest mit dem zweiten Trägerelement, wobei die Sensoreinrichtung zumindest ein Sensorelement aufweist, wobei jedes Sensorelement ausgebildet ist, um ein zugeordnetes Messsignal bereitzustellen und wobei die Sensoreinrichtung ausgebildet ist, um Störeinflüsse auf das zumindest eine Sensorelement zumindest teilweise zu korrigieren;
Anordnen (1330) eines ersten Trägerelements und eines zweiten Trägerelements, so dass eine relative Lage des ersten Trägerelements und des zweiten Trägerelements zueinander veränderlich ist;
so dass das Sensorsignal die relative Lage der Trägerelemente zueinander anzeigt.

15. Verfahren gemäß Anspruch 14, bei dem das Verbinden der permanentmagnetischen Einrichtung folgende Schritte umfasst:
Erzeugen einer Aussparung in einem Bereich des ersten Trägerelements;
Einfüllen einer Vielzahl von magnetischen oder magnetisierbaren Mikropartikeln in die Aussparung; und
Verfestigen der Vielzahl von magnetischen oder magnetisierbaren Mikropartikeln mittels einer Atomlagenabscheidung.

## Claims

1. A microsystem comprising:
a first support element (12₁) and a second support element (12₂), wherein a relative position of the first support element (12₁) and the second support element (12₂) relative to each other is variable;
a permanent-magnetic means (14) connected to the first support element (12₁) in a mechanically fixed manner and configured to generate a magnetic field;
a sensor means (18) connected to the second support element (12₂) in a mechanically fixed manner and configured to detect the magnetic field and to provide a sensor signal (22) which is based on the magnetic field;
wherein the sensor signal (22) indicates the relative position of the support elements (12₁, 12₂) relative to each other;
**characterized in that**
the sensor means (18) comprises at least one sensor element (18₁-18₄), wherein each sensor element (18₁-18₄) is configured to provide an associated measuring signal (64) and the sensor means (18) is configured to correct disturbing influences on the at least one sensor element (18₁-18₄) at least partly.

2. The microsystem in accordance with claim 1, wherein the permanent-magnetic means (14) comprises at least one permanent-magnetic element (14₁) having a plurality of particles connected among one another to form a fixed three-dimensional structure by means of a coating.

3. The microsystem in accordance with claim 1 or 2, wherein the permanent-magnetic means (14) comprises at least one permanent-magnetic element (14₁) structurally integrated in the first support element (12₁).

4. The microsystem in accordance with any of the preceding claims, wherein the permanent-magnetic means (14) comprises a number of at least one permanent-magnetic element (14₁-14₄) for generating a magnetic field associated to the permanent-magnetic element (14₁-14₄); wherein the sensor means (18) comprises a number of sensor elements (18₁-18₄), wherein at least a first and a second sensor element (18₁-18₄) are associated to each permanent-magnetic element (14₁-14₄) of the number of permanent-magnetic elements, the sensor means (18) being configured to provide the sensor signal (22) based on an at least differential evaluation of the magnetic field by a measurement at least with the first sensor element (18) and the second sensor element (18₂).

5. The microsystem in accordance with any of the preceding claims, wherein the permanent-magnetic means (14) comprises a first permanent-magnetic element for generating a first magnetic field associated to the first permanent-magnetic element and a second permanent-magnetic element for generating a second magnetic field associated to the second permanent-magnetic element; the sensor means (18) comprising a sensor element associated to the first permanent-magnetic element and the second permanent-magnetic element and configured to detect overlapping of the first magnetic field and the second magnetic field.

6. The microsystem in accordance with any of the preceding claims, wherein the sensor means (18) comprises a reference sensor element (18₃) configured to detect a reference magnetic field and provide a reference signal (62), the sensor means (18) being configured to adjust the measuring signal (64) or the sensor signal (22) using the reference signal (62) to correct the disturbing influences at least partly.

7. The microsystem in accordance with claim 6, wherein the reference magnetic field is an environmental magnetic field of the microsystem.

8. The microsystem in accordance with claim 6, wherein the sensor means comprises a reference magnetic source (66) configured to generate the reference magnetic field.

9. The microsystem in accordance with claim 8, wherein a relative position between the reference magnetic source (66) and the reference sensor element (18₃) is fixed.

10. The microsystem in accordance with any of claims 6 to 9, wherein the reference signal (62) is essentially uninfluenced by a change in the relative position.

11. The microsystem in accordance with any of the preceding claims, wherein the first support element (12₁) is shiftable relatively in a translatory manner relative to the second support element (12₂) along at least one axis and/or is tiltable relatively to the second support element (12₂).

12. The microsystem in accordance with any of the preceding claims, wherein the first support element (12₁) or the second support element (12₂) is formed as a plate element.

13. The microsystem in accordance with any of the preceding claims, wherein a direction of a change of the relative position is based on:
at least an orientation of a spring element (24₁) between the first support element (12₁) and the second support element (12₂); or
at least an axis of rotation for allowing rotation of the first support element (12₁) or the second support element (12₂); or
at least a limitation surface or limitation edge along which a movement of the first support element and/or the second support element is preset.

14. A method (1300) for producing a microsystem, comprising the steps of:
connecting (1310) a permanent-magnetic means configured to generate a magnetic field, to the first support element in a mechanically fixed manner;
connecting (1320) a sensor means configured to detect the magnetic field and provide a sensor signal which is based on the magnetic field, to the second support element in a mechanically fixed manner, wherein the sensor means comprises at least one sensor element, wherein each sensor element is configured to provide an associated measuring signal and wherein the sensor means is configured to correct disturbing influences on the at least one sensor element at least partly.
arranging (1330) a first support element and a second support element such that a relative position of the first support element and of the second support element among each other is variable;
so that the sensor signal indicates the relative position of the support elements among one another.

15. The method in accordance with claim 14, wherein connecting the permanent-magnetic means comprises the steps of:
producing a recess in a region of the first support element;
filling a plurality of magnetic or magnetizable microparticles into the recess; and
solidifying the plurality of magnetic or magnetizable microparticles by means of atomic layer deposition.

## Revendications

1. Microsystème comprenant:
un premier élément de support (12₁) et un deuxième élément de support (12₂), dans lequel la position relative du premier élément de support (12₁) et du deuxième élément de support (12₂) l'un par rapport à l'autre est variable;
un dispositif à aimant permanent (12₁) relié mécaniquement de manière fixe au premier élément de support (14), conçu pour générer un champ magnétique;
un dispositif de détection (12₂) relié mécaniquement de manière fixe au deuxième élément de support (18), conçu pour détecter le champ magnétique et pour fournir un signal de capteur (22) basé sur ledit champ magnétique;
dans lequel le signal de capteur (22) indique la position relative des éléments de support (12₁, 12₂) l'un par rapport à l'autre;
**caractérisé en ce que**
le dispositif de détection (18) comprend au moins un élément capteur (18₁-18₄), dans lequel chaque élément capteur (18₁-18₄) est conçu pour fournir un signal de mesure associé (64), et dans lequel le dispositif de détection (18) est conçu pour corriger au moins partiellement les influences perturbatrices affectant ledit au moins un élément capteur (18₁-18₄).

2. Microsystème selon la revendication 1, dans lequel le dispositif à aimant permanent (14) comprend au moins un élément à aimant permanent (14₁) comprenant une multitude de particules reliées entre elles au moyen d'un revêtement pour former une structure tridimensionnelle solide.

3. Microsystème selon la revendication 1 ou 2, dans lequel le dispositif à aimant permanent (14) comprend au moins un élément à aimant permanent (14₁) qui est intégré structurellement dans le premier élément de support (12₁).

4. Microsystème selon l'une des revendications précédentes, dans lequel le dispositif à aimant permanent (14) comprend un nombre d'au moins un élément à aimant permanent (14₁-14₄) pour générer un champ magnétique associé à l'élément à aimant permanent (14₁-14₄); dans lequel le dispositif de détection (18) comprend un nombre d'éléments capteurs (18₁-18₄), où au moins un premier élément capteur et au moins un deuxième élément capteur (14₁-14₄) sont associés à chaque élément à aimant permanent (18₁-18₄) dudit nombre d'éléments à aimant permanent, dans lequel le dispositif de détection (18) est conçu pour fournir le signal de capteur (22) sur la base d'une évaluation au moins différentielle du champ magnétique par mesure au moins au moyen du premier élément capteur (18) et du deuxième élément capteur (18₂).

5. Microsystème selon l'une des revendications précédentes, dans lequel le dispositif à aimant permanent (14) comprend un premier élément à aimant permanent pour générer un premier champ magnétique associé au premier élément à aimant permanent et un deuxième élément à aimant permanent pour générer un deuxième champ magnétique associé au deuxième élément à aimant permanent; dans lequel le dispositif de détection (18) comprend un élément capteur associé au premier élément à aimant permanent et au deuxième élément à aimant permanent, et étant conçu pour détecter une superposition du premier champ magnétique et du deuxième champ magnétique.

6. Microsystème selon l'une des revendications précédentes, dans lequel le dispositif de détection (18) comprend un élément capteur de référence (18₃) conçu pour détecter un champ magnétique de référence et fournir un signal de référence (62), dans lequel le dispositif de détection (18) est conçu pour adapter le signal de mesure (64) ou le signal de capteur (22) au moyen du signal de référence (62) afin de corriger au moins partiellement les influences perturbatrices.

7. Microsystème selon la revendication 6, dans lequel le champ magnétique de référence est un champ magnétique ambiant du microsystème.

8. Microsystème selon la revendication 6, dans lequel le dispositif de détection comprend une source magnétique de référence (66) conçue pour générer le champ magnétique de référence.

9. Microsystème selon la revendication 8, dans lequel une position relative entre la source magnétique de référence (66) et l'élément capteur de référence (18₃) est fixée.

10. Microsystème selon l'une des revendications 6 à 9, dans lequel le signal de référence (62) est essentiellement non affecté par une modification de la position relative.

11. Microsystème selon l'une des revendications précédentes, dans lequel le premier élément de support (12₁) est déplaçable en translation relativement au deuxième élément de support (12₂) le long d'au moins un axe, et/ou est inclinable relativement au deuxième élément de support (12₂).

12. Microsystème selon l'une des revendications précédentes, dans lequel le premier élément de support (12₁) ou le deuxième élément de support (12₂) est réalisé sous la forme d'un élément en plaque.

13. Microsystème selon l'une des revendications précédentes, dans lequel une direction d'une modification de la position relative repose
sur au moins une orientation d'un élément élastique (24₁) entre le premier élément de support (12₁) et le deuxième élément de support (12₂); ou
sur au moins un axe de rotation permettant une rotation du premier élément de support (12₁) ou du deuxième élément de support (12₂); ou
sur au moins une surface de limitation ou une arête de limitation, le long de laquelle un déplacement du premier élément de support et/ou du deuxième élément de support est prédéfini.

14. Procédé (1300) de fabrication d'un microsystème, comprenant le fait de :
relier (1310) mécaniquement de manière fixe au premier élément de support un dispositif à aimant permanent conçu pour générer un champ magnétique;
relier (1320) mécaniquement de manière fixe au deuxième élément de support un dispositif de détection conçu pour détecter le champ magnétique et pour fournir un signal de capteur basé sur ce champ magnétique, dans lequel le dispositif de détection comprend au moins un élément capteur, dans lequel chaque élément capteur est conçu pour fournir un signal de mesure associé, et dans lequel le dispositif de détection est conçu pour corriger au moins partiellement les influences perturbatrices affectant ledit au moins un élément capteur;
disposer (1330) un premier élément de support et un deuxième élément de support de telle sorte que la position relative du premier élément de support et du deuxième élément de support l'un par rapport à l'autre soit variable;
de sorte que le signal de capteur indique la position relative des éléments de support l'un par rapport à l'autre.

15. Procédé selon la revendication 14, dans lequel la liaison du dispositif à aimant permanent comprend le fait de :
réaliser un évidement dans une zone du premier élément de support;
introduire une multitude de microparticules magnétiques ou magnétisables dans l'évidement; et
solidifier la multitude de microparticules magnétiques ou magnétisables au moyen d'un dépôt de couches atomiques.
